# EUROPEAN PATENT APPLICATION

(11) **EP 4 682 962 A1**
(43) Date of publication of application: **21.01.2026**
(21) Application number: 24775099.5
(22) Date of filing: 06.03.2024
(51) Int. Cl.: H01L 33/10, H01L 33/14, H01L 33/40, H01L 33/20, H01L 33/26, H01L 27/15

(54) **LIGHT-EMITTING DEVICE AND DISPLAY APPARATUS COMPRISING SAME**

(30) Priority: 17.03.2023 KR 20230035150
(71) Applicant: Samsung Display Co., Ltd., Yongin-si, Gyeonggi-do 17113 (KR)
(72) Inventor: CHOI, Hyeong Su, Yongin-si, Gyeonggi-do 17113 (KR); KIM, Dae Hyun, Yongin-si, Gyeonggi-do 17113 (KR); KIM, In Hyuk, Yongin-si, Gyeonggi-do 17113 (KR); SEO, Dong Kyun, Yongin-si, Gyeonggi-do 17113 (KR); SIM, Young Chul, Yongin-si, Gyeonggi-do 17113 (KR); YOO, Chul Jong, Yongin-si, Gyeonggi-do 17113 (KR); JANG, Choel Min, Yongin-si, Gyeonggi-do 17113 (KR); JIN, Tae Ha, Yongin-si, Gyeonggi-do 17113 (KR)
(74) Representative: Marks & Clerk LLP
(86) International application number: PCT/KR2024/002897
(87) International publication number: WO 2024/196051

(57) **Abstract**

A light emitting element may include: a light emitting stack pattern including a first semiconductor layer, an active layer, and a second semiconductor layer; and an insulating film surrounding an outer circumferential surface of the light emitting stack pattern. The insulating film may include: a first layer; a second layer surrounding the first layer; and a third layer surrounding the second layer. The first layer and the third layer may include the same material.

## Description

### Technical Field

The present disclosure generally relates to a light emitting element and a display device comprising the light emitting element.

### Background Art

Recently, as interest in information displays is increased, research and development of display devices have been continuously conducted.

### Detailed Description of Invention

### Technical Problem

Embodiments provide a light emitting element having improved reliability and a display device comprising the light emitting element.

### Technical Solution

In accordance with an aspect of the present disclosure, there is provided a light emitting element including: a light emitting stack pattern including a first semiconductor layer, an active layer, and a second semiconductor layer; and an insulating film surrounding an outer circumferential surface of the light emitting stack pattern, wherein the insulating film includes: a first layer; a second layer surrounding the first layer; and a third layer surrounding the second layer, and wherein the first layer and the third layer include the same material.

The first layer and the third layer may include at least one of ZrOₓ, SiOₓ, HFOₓ, BeO, TaₓO_{y}, AlₓO_{y}, LaₓO_{y}, NbₓO_{y}, TiOₓ, CeOₓ, MgO, YₓO_{y}, and SrₓO_{y}.

The first layer and the third layer may include at least one of AIN, AlGaN, InGaN, SiNₓ, AlOₓN_{y}, HfN, ZrN, HfOₓN_{y}, and ZrOₓN_{y}.

The first layer may have a thickness of 5 nm or less, and the third layer may have a thickness of 10 nm or less.

The second layer may include a material different from the material of the first and third layers.

The first layer may be disposed directly on an outer circumferential surface of each of the first semiconductor layer, the active layer, and the second semiconductor layer.

The first semiconductor layer may include an n-type semiconductor layer doped with an n-type dopant, and the second semiconductor layer may include a p-type semiconductor layer doped with a p-type dopant.

The light emitting stack pattern may further include an electrode layer disposed on the second semiconductor layer. The insulating film may be disposed directly on an outer circumferential surface of each of the first semiconductor layer, the active layer, the second semiconductor layer, and the electrode layer.

The insulating film may further include a fourth layer surrounding the third layer. The fourth layer may include an inorganic insulating material, and have a thickness thicker than a thickness of each of the first to third layers.

The insulating film may further include a fifth layer surrounding the fourth layer. The fifth layer may include an inorganic insulating material, and have a thickness thicker than a thickness of each of the first to fourth layers.

In accordance with another aspect of the present disclosure, there is provided a light emitting element including: a light emitting stack pattern including a first semiconductor layer, an active layer, a second semiconductor layer, and an electrode layer, which are sequentially stacked along one direction; and an insulating film surrounding an outer circumferential surface of the light emitting stack pattern, wherein the insulating film includes: a first layer disposed directly on the outer circumferential surface of the light emitting stack pattern to surround the light emitting stack pattern; a second layer surrounding the first layer; a third layer surrounding the second layer; a fourth layer surrounding the third layer; and a fifth layer surrounding the fourth layer, and wherein the first layer and the third layer include the same material, and the second layer includes a material different from a material of the first and third layers.

The first layer and the third layer may include at least one of ZrOₓ, SiOₓ, HFOₓ, BeO, TaₓO_{y}, AlₓO_{y}, LaₓO_{y}, NbₓO_{y}, TiOₓ, CeOₓ, MgO, YₓO_{y}, and SrₓO_{y}.

The first layer and the third layer may include at least one of AIN, AlGaN, InGaN, SiNₓ, AlOₓN_{y}, HfN, ZrN, HfOₓN_{y}, and ZrOₓN_{y}.

The first layer may have a thickness of 5 nm or less, and the third layer may have a thickness of 10 nm or less.

The fourth layer and the fifth layer may include an inorganic insulating material.

In accordance with still another aspect of the present disclosure, there is provided a display device including: a substrate; a first electrode and a second electrode disposed on the substrate to be spaced apart from each other; and a light emitting element located on the substrate, the light emitting element including a first end portion electrically connected to the first electrode and a second end portion electrically connected to the second electrode, wherein the light emitting element includes: a light emitting stack pattern including a first semiconductor layer located at the second end portion, an active layer disposed on the first semiconductor layer, a second semiconductor layer disposed on the active layer, and an electrode layer which is disposed on the second semiconductor layer and is located at the first end portion; and an insulating film surrounding an outer circumferential surface of the light emitting stack pattern, wherein the insulating film includes: a first layer disposed directly on the outer circumferential surface of the light emitting stack pattern; a second layer surrounding the first layer; and a third layer surrounding the second layer, and wherein the first layer and the third layer include the same material, and the second layer includes a material different from the material of the first and third layers.

The first layer and the third layer may include at least one of ZrOₓ, SiOₓ, HFOₓ, BeO, TaₓO_{y}, AlₓO_{y}, LaₓO_{y}, NbₓO_{y}, TiOₓ, CeOₓ, MgO, YₓO_{y}, and SrₓO_{y}.

The first layer and the third layer may include at least one of AIN, AlGaN, InGaN, SiNₓ, AlOₓN_{y}, HfN, ZrN, HfOₓN_{y}, and ZrOₓN_{y}.

The first layer may have a thickness of 5 nm or less, and the third layer may have a thickness of 10 nm or less.

The display device may further include: an emission area in which light is emitted from the light emitting element and a non-emission area surrounding the emission area; a first alignment electrode disposed between the substrate and the first electrode, the first alignment electrode being electrically connected to the first electrode; a second alignment electrode disposed between the substrate and the second electrode, the second alignment electrode being electrically connected to the second electrode; a first bank located in the non-emission area, the first bank including an opening corresponding to the emission area; a second bank located on the first bank; a color conversion layer surrounded by the second bank, the color conversion layer being located above the light emitting element; and a color filter disposed on the color conversion layer.

### Advantageous Effects

In accordance with the present disclosure, a multi-layer insulating film including a first layer, a second layer, and a third layer is disposed on an outer circumferential surface of a light emitting stack pattern including a first semiconductor layer, an active layer, and a second semiconductor layer, and the first layer and the third layer are configured with the same material. Thus, a surface defect of the light emitting stack pattern is effectively controlled, and a protective layer characteristic of the insulating film is improved. Accordingly, the lifetime and efficiency of a light emitting element can be improved.

In accordance with the present disclosure, there can be provided a display device including the above-described light emitting element.

The effects of the present disclosure are not limited by the foregoing, and other various effects are anticipated herein.

### Description of Drawings

FIG. 1 is a schematic perspective view of a light emitting element in accordance with an embodiment of the present disclosure.
FIG. 2 is a schematic view, viewed from the top of the light emitting element shown in FIG. 1.
FIG. 3 is a schematic cross-sectional view of the light emitting element shown in FIG. 1.
FIG. 4 is a schematic perspective view of a light emitting element in accordance with an embodiment of the present disclosure.
FIG. 5 is a schematic view, viewed from the top of the light emitting element shown in FIG. 4.
FIG. 6 is a schematic cross-sectional view of the light emitting element shown in FIG. 3.
FIG. 7 is a schematic perspective view of a light emitting element in accordance with an embodiment of the present disclosure.
FIG. 8 is a schematic view, viewed from the top of the light emitting element shown in FIG. 7.
FIG. 9 is a schematic cross-sectional view of the light emitting element shown in FIG. 5.
FIG. 10 is a schematic plan view of a display device in accordance with an embodiment of the present disclosure.
FIG. 11 is a schematic circuit diagram illustrating an electrical connection relationship of components included in each of pixels shown in FIG. 10.
FIG. 12 is a schematic plan view illustrating a pixel in accordance with an embodiment of the present disclosure.
FIGS. 13 and 14 are schematic cross-sectional views taken along line I-I' shown in FIG. 12.
FIG. 15 is a schematic enlarged view illustrating portion EA shown in FIG. 13.
FIGS. 16 and 17 are schematic cross-sectional views corresponding to the line I-I' shown in FIG. 12.

### Modes of the Invention

The present disclosure may apply various changes and different shape, therefore only illustrate in details with particular examples. However, the examples do not limit to certain shapes but apply to all the change and equivalent material and replacement.

Like numbers refer to like elements throughout. In the drawings, the thickness of certain lines, layers, components, elements or features may be exaggerated for clarity. It will be understood that, although the terms "first," "second," etc. may be used herein to describe various elements, these elements should not be limited by these terms. These terms are only used to distinguish one element from another element. For example, a "first" element discussed below could also be termed a "second" element without departing from the teachings of the present disclosure, similarly a "second" element discussed below could also be termed a "first" element.

It will be further understood that the terms "includes" and/or "including," when used in this specification, specify the presence of stated features, integers, steps, operations, elements, and/or components, but do not preclude the presence and/or addition of one or more other features, integers, steps, operations, elements, components, and/or groups thereof. Further, an expression that an element such as a layer, region, substrate or plate is placed "on" or "above" another element indicates not only a case where the element is placed "directly on" or "just above" the other element but also a case where a further element is interposed between the element and the other element. On the contrary, an expression that an element such as a layer, region, substrate or plate is placed "beneath" or "below" another element indicates not only a case where the element is placed "directly beneath" or "just below" the other element but also a case where a further element is interposed between the element and the other element.

Hereinafter, preferred exemplary embodiments of the present disclosure and items required for those skilled in the art to easily understand the content of the present disclosure will be described in detail with reference to the accompanying drawings. In the following description, singular forms in the present disclosure are intended to include the plural forms as well, unless the context clearly indicates otherwise.

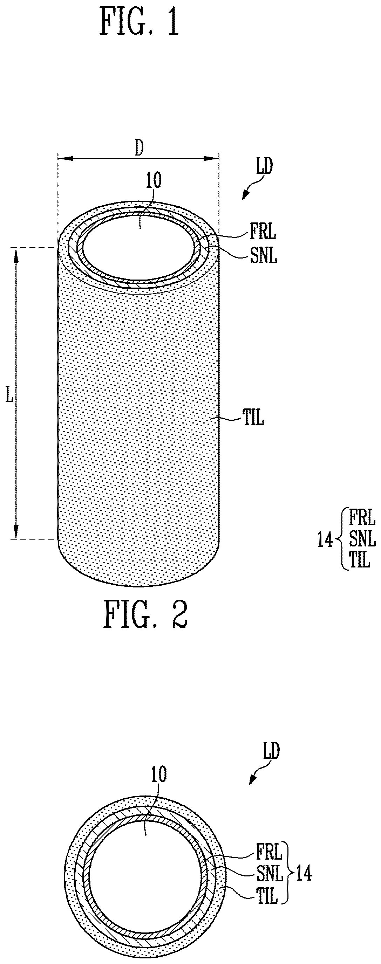

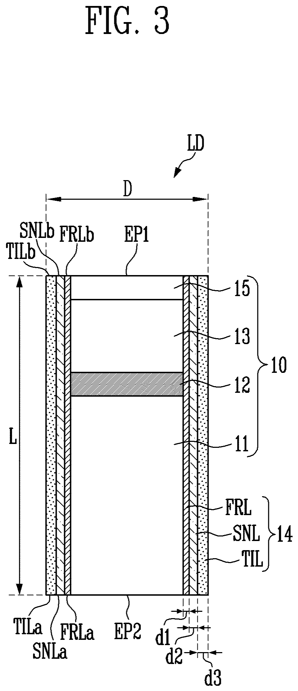

FIG. 1 is a schematic perspective view of a light emitting element LD in accordance with an embodiment of the present disclosure. FIG. 2 is a schematic view, viewed from the top of the light emitting element LD shown in FIG. 1. FIG. 3 is a schematic cross-sectional view of the light emitting element LD shown in FIG. 1.

Referring to FIGS. 1 to 3, the light emitting element LD may have a shape extending in one direction. In the case that assumes that an extending direction of the light emitting element LD is a length direction, the light emitting element LD may include a first end portion EP1 and a second end portion EP2, which face each other along the length direction.

The light emitting element LD may include a light emitting stack pattern 10 and an insulating film 14 surrounding an outer circumferential surface of the light emitting stack pattern 10. For example, the light emitting element LD may include a light emitting stack pattern 10 (or light emitting pattern) in which a first semiconductor layer 11, an active layer 12, and a second semiconductor layer 13 are stacked on each other, and an insulating film 14 surrounding an outer circumferential surface of the light emitting stack pattern 10.

The light emitting element LD may be provided in various shapes. For example, the light emitting element LD may have a rod-like shape, a bar-like shape, a pillar-like shape, or the like, which is long in its length direction (e.g., its aspect ratio is greater than 1). Also, the light emitting element LD may have a rod-like shape, a bar-like shape, a pillar-like shape, or the like, which is short in its length direction. However, the shape of the light emitting element LD is not limited thereto. The shape of the light emitting element LD may correspond to a shape of the light emitting stack pattern 10. For example, in the case that the light emitting stack pattern 10 has a pillar-like shape such as a cylinder, the light emitting element LD may also have a cylindrical shape.

The light emitting element LD may include, for example, a light emitting diode (LED) manufactured small enough to have a diameter D and/or a length L to a degree of a nano scale (or nanometers) to a micro scale (micrometers).

In the case that the light emitting element LD is long in its length direction, the diameter D of the light emitting element LD may be about 0.5 µm to about 6 µm, and the length L of the light emitting element LD may be about 1 µm to about 10 µm. However, the diameter D and the length L of the light emitting element LD are not limited thereto, and the size of the light emitting element LD may be changed to accord with requirement conditions (or design conditions) of a lighting device or a self-luminous display device, to which the light emitting element LD is applied.

One of the first semiconductor layer 11 and the second semiconductor layer 13 may be located at the first end portion EP1 of the light emitting element LD, and the other of the first semiconductor layer 11 and the second semiconductor layer 13 may be located at the second end portion EP2 of the light emitting element LD. For example, the second semiconductor layer 13 (or p-type semiconductor layer) or an electrode layer 15 in ohmic contact with the second semiconductor layer 13 may be located at the first end portion EP1 of the light emitting element LD, and the first semiconductor layer 11 (or n-type semiconductor layer) may be located at the second end portion EP2 of the light emitting element LD.

The first semiconductor layer 11 may include, for example, at least one n-type semiconductor layer. For example, the first semiconductor layer 11 may include at least one semiconductor material among InAlGaN, GaN, AlGaN, InGaN, AIN, and InN, and include an n-type semiconductor layer doped with a first conductive dopant (or n-type dopant) such as Si, Ge or Sn. However, the material constituting the first semiconductor layer 11 is not limited thereto. In addition, the first semiconductor layer 11 may be configured with various materials.

The active layer 12 may emit light having a wavelength of about 400 nm to about 900 nm, and use a double hetero structure. Light emitted from the active layer 12 may be emitted to not only an outer surface of the light emitting element LD in the length direction but also both the end portions of the light emitting element LD. The directionality of light emitted from the active layer 12 is not limited to one direction. In an embodiment, a clad layer doped with a conductive dopant may be formed on the top and/or the bottom of the active layer 12 along the length direction of the light emitting element LD. The clad layer may include an AlGaN layer or InAlGaN layer. In some embodiments, a material such as AlGaN or AlInGaN may be used to form the active layer 12. In addition, the active layer 12 may be configured with various materials. The active layer 12 may include a first surface in contact with the first semiconductor layer 11 and a second surface in contact with the second semiconductor layer 13.

In the case that an electric field having a predetermined or selected voltage or more is applied to both the end portions of the light emitting element LD, the light emitting element LD may emit light as electron-hole pairs are combined in the active layer 12. The light emission of the light emitting element LD is controlled by using such a principle, so that the light emitting element LD can be used as a light source for various light emitting devices, including a pixel of a display device.

The second semiconductor layer 13 may be disposed on the active layer 12, and include a semiconductor layer having a type different from the type of the first semiconductor layer 11. For example, the second semiconductor layer 13 may include at least one p-type semiconductor material. For example, the second semiconductor layer 13 may include at least one semiconductor material among InAlGaN, GaN, AlGaN, InGaN, AIN, and InN, and include a p-type semiconductor layer doped with a second conductive dopant (or p-type dopant) such as Mg, Zn, Ca, Sr or Ba. However, the material constituting the second semiconductor layer 13 is not limited thereto. In addition, the second semiconductor layer 13 may be configured with various materials.

The first semiconductor layer 11 and the second semiconductor layer 13 may have different thicknesses in the length direction of the light emitting element LD. For example, the first semiconductor layer 11 may have a thickness relatively thicker than a thickness of the second semiconductor layer 13 along the length direction of the light emitting element LD. However, the present disclosure is not limited thereto. In some embodiments, the first semiconductor layer 11 and the second semiconductor layer 13 may have thicknesses substantially similar or equal to each other in the length direction of the light emitting element LD.

Although a case where each of the first semiconductor layer 11 and the second semiconductor layer 13 is configured with one layer is illustrated in FIG. 3, the present disclosure is not limited thereto. In an embodiment, each of the first semiconductor layer 11 and the second semiconductor layer 13 may further include at least one layer, e.g., a clad layer and/or a Tensile Strain Barrier Reducing (TSBR) layer according to the material of the active layer 12.

In an embodiment, the light emitting element LD (or the light emitting stack pattern 10) may include an electrode layer 15 disposed on the second semiconductor layer 13.

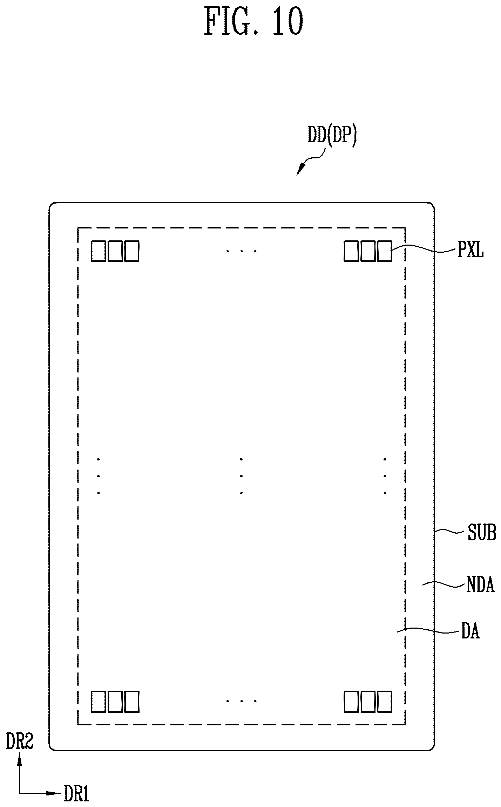

The electrode layer 15 may be an ohmic contact electrode, but the present disclosure is not limited thereto. In some embodiments, the electrode layer 15 may be a Schottky contact electrode. In the case that the light emitting element LD is electrically connected to an alignment electrode or an electrode in a display device (see "DD" shown in FIG. 10), the electrode layer 15 may reduce resistance between the light emitting element LD and the alignment electrode or the electrode. The electrode layer 15 may include a conductive material. For example, the electrode layer 15 may include an opaque metal using one or mixture of chromium, titanium, aluminium, gold, nickel, and any oxide or alloy thereof, but the present disclosure is not limited thereto. In some embodiments, the electrode layer 15 may include a transparent conductive oxide such as indium tin oxide (ITO), indium zinc oxide (IZO), zinc oxide (ZnOₓ), indium gallium zinc oxide (IGZO), or indium tin zinc oxide (ITZO).

The insulating film 14 may be disposed on the outer circumferential surface (or outer surface) of the light emitting stack pattern 10 including the first semiconductor layer 11, the active layer 12, the second semiconductor layer 13, and the electrode layer 15, which are stacked on each other in one direction (e.g., a direction toward the first end portion EP1 from the second end portion EP2). For example, the insulating film 14 may surround the outer circumferential surface of the light emitting stack pattern 10. In some embodiment, the insulating film 14 may surround only a portion of the light emitting stack pattern 10.

The insulating film 14 may expose both end portions of the light emitting stack pattern 10, which have different polarities. For example, the insulating film 14 may expose each of a portion of the electrode layer 15 located at the first end portion EP1 of the light emitting stack pattern 10 and a portion of the first semiconductor layer 11 located at the second end portion EP2 of the light emitting stack pattern 10.

The insulating film 14 can prevent an electrical short circuit which may occur in the case that the active layer 12 is in contact with a conductive material in addition to the first semiconductor layer 11 and the second semiconductor layer 13. Also, the insulating film 14 minimizes a surface defect of the light emitting stack pattern 10, thereby improving the lifetime and light emission efficiency of the light emitting element LD. Also, in the case that a plurality of light emitting elements LD are densely disposed, the insulating film 14 can prevent an unwanted short circuit which may occur between the light emitting elements LD.

The insulating film 14 may be disposed to surround an outer circumferential surface of the light emitting stack structure 10. The outer circumferential surface of the light emitting stack structure 10 may be a side surface except the first end portion EP1 and the second end portion EP2 of the light emitting element LD.

The insulating film 14 may be disposed to surround an outer circumferential surface (surface or outer surface) of each of the first semiconductor layer 11, the active layer 12, the second semiconductor layer 13, and the electrode layer 15. The insulating film 14 may be disposed to surround outer circumferential surfaces of all of the first semiconductor layer 11, the active layer 12, the second semiconductor layer 13, and the electrode layer 15, or be disposed to surround outer circumferential surfaces of some of the first semiconductor layer 11, the active layer 12, the second semiconductor layer 13, and the electrode layer 15. The insulating film 14 may be formed in an area in which the light emitting stack pattern 10 has a high surface defect concentration, to effectively control the surface defect of the light emitting stack pattern 10.

The insulating film 14 may include a transparent insulating material. Various materials having insulating properties may be used as the material of the insulating film 14.

The insulating film 14 may be provided in the form of a multi-layer including at least three layers. In an embodiment, the insulating film 14 may include a first layer FRL, a second layer SNL, and a third layer TIL. The first layer FRL may be directly disposed on the outer circumferential surface of the light emitting stack pattern 10 to surround the light emitting stack pattern 10. The second layer SNL may be disposed on the first layer FRL to surround the first layer FRL. The third layer TIL may be disposed on the second layer SNL to surround the second layer SNL.

The third layer TIL may be an outer circumferential surface (or surface) of the light emitting element LD. For example, the third layer TIL may be located at an outermost portion in a side surface of the light emitting element LD.

The first layer FRL may include a first surface FRLa and a second surface FRLb, which face each other in the length direction of the light emitting element LD. In a direction perpendicular to the length direction of the light emitting element LD, the first surface FRLa may be located on the same line as the second end portion EP2 of the light emitting element LD, and the second surface FRLb may be located on the same line as the first end portion EP1 of the light emitting element LD. However, the present disclosure is not limited thereto.

The second layer SNL may include a first surface SNLa and a second surface SNLb, which face each other in the length direction of the light emitting element LD. In the direction perpendicular to the length direction of the light emitting element LD, the first surface SNLa may be located on the same line as the second end portion EP2 of the light emitting element LD, and the second surface SNLb may be located on the same line as the first end portion EP1 of the light emitting element LD. However, the present disclosure is not limited thereto.

The third layer TIL may include a first surface TILa and a second surface TILb, which face each other in the length direction of the light emitting element LD. In the direction perpendicular to the length direction of the light emitting element LD, the first surface TILa may be located on the same line as the second end portion EP2 of the light emitting element LD, and the second surface TILb may be located on the same line as the first end portion EP1 of the light emitting element LD. However, the present disclosure is not limited thereto.

In an embodiment, the first layer FRL and the third layer TIL may include the same material. For example, the first layer FRL and the third layer TIL may include at least one of zirconium oxide (ZrOₓ), silicon oxide (SiOₓ), hafnium oxide (HfOₓ), beryllium oxide (BeO), tantalum oxide (TaₓO_{y}), aluminium oxide (AlₓO_{y}), lanthanum oxide (LaₓO_{y}), niobium oxide (NbₓO_{y}), titanium oxide (TiOₓ), cerium oxide (CeOₓ), magnesium oxide (MgO), yttrium oxide (YₓO_{y}), and strontium oxide (SrₓO_{y}). Also, the first layer FRL and the third layer TIL may include at least one of aluminium nitride (AIN), hafnium nitride (HfN), zirconium nitride (ZrN), silicon nitride (SiNₓ), aluminium oxynitride (AlOₓN_{y}), hafnium oxynitride (HfOₓN_{y}), zirconium oxynitride (ZrOₓN_{y}), AlGaN, and InGaN. In an embodiment, the first layer FRL and the third layer TIL may include at least one of zirconium oxide (ZrOₓ), hafnium oxide (HfOₓ), zirconium nitride (ZrN), hafnium nitride (HfN), zirconium oxynitride (ZrOₓN_{y}), and hafnium oxynitride (HfOₓN_{y}).

The second layer SNL may be configured with a material different from the material of the first and third layers FRL and TIL. The second layer SNL may be configured with a material different from the material of the first and third layers FRL and TIL among the materials exemplified as the material constituting the first and third layers FRL and TIL. For example, in the case that the first and third layers FRL and TIL include at least one of zirconium oxide (ZrOₓ), hafnium oxide (HfOₓ), zirconium nitride (ZrN), hafnium nitride (HfN), zirconium oxynitride (ZrOₓN_{y}), and hafnium oxynitride (HfOₓN_{y}), the second layer SNL may include aluminium oxide (AlₓO_{y}).

The first layer FRL may surround the outer circumferential surface of the light emitting stack pattern 10 with a thickness d1 of 5 nm or less. The first layer FRL may be configured to have a relatively thin thickness d1 as compared with the second and third layers SNL and TIL. The second layer SNL may have a thickness d2 thicker than the thickness of the first layer FRL, and surround the first layer FRL. The third layer TIL may have a thickness d3 relatively thicker than the thickness of each of the first and second layers FRL and SNL. However, the present disclosure is not limited thereto. In some embodiments, the third layer TIL may be formed thinner than the first layer FRL.

The first layer FRL may be coated in a form entirely surrounding the side surface and both the end portions of the light emitting stack structure in a desired shape, the second layer SNL may be coated in a form entirely surrounding the first layer FRL, and the third layer TIL may be coated in a form entirely surrounding the second layer SNL. Portions of the first, second, and third layers FRL, SNL, and TIL may be removed such that each of portions of the electrode layer 15 located at the first end portion EP1 of the light emitting element LD and the first semiconductor layer 11 located at the second end portion EP2 of the light emitting element LD is exposed in an etching process performed subsequently, thereby finally forming the insulating film 14 surrounding the outer circumferential surface of the light emitting stack pattern 10 (e.g., a side surface except the first end portion EP1 and the second end portion EP2). However, the method of forming the insulating film 14 is not limited thereto.

An etching process may be generally performed so as to manufacture the light emitting stack pattern 10. As atoms of the outer circumferential surface (or surface) of the light emitting stack pattern 10 are partially lacked due to the etching process, a surface defect of the light emitting stack pattern 10 may occur due to a vacancy or a dangling bond. In the case that the light emitting element LD has a size of nanometers or micrometers, the surface defect of the light emitting stack pattern 10 may be further increased as a ratio of surface area to volume become larger. The first layer FRL may be directly disposed on the outer circumferential surface of the light emitting stack pattern 10, to reduce a surface defect occurring in a manufacturing process of the light emitting stack pattern 10. For example, in the case that the first layer FRL includes at least one of zirconium oxide (ZrOₓ), hafnium oxide (HfOₓ), zirconium nitride (ZrN), hafnium nitride (HfN), zirconium oxynitride (ZrOₓN_{y}), and hafnium oxynitride (HfOₓN_{y}), a lattice defect which may occur between the first layer FRL and the light emitting stack pattern 10 can be reduced. As the first layer FRL is properly grown on the outer circumferential surface of the light emitting stack pattern 10, the outer circumferential surface of the light emitting stack pattern 10 is protected, thereby reducing the surface defect of the light emitting stack pattern 10.

In the case that the thickness d1 of the first layer FRL is 5 nm or less (i.e., in the case that the thickness d1 of the first layer FRL is thin as compared with a general thin film process), only an interface characteristic between the light emitting stack pattern 10 and the first layer FRL can be controlled. However, in the case that the thickness d1 of the first layer FRL is increased (or in the case that another layer including the same material as the first layer FRL surrounds the first layer FRL), the first layer FRL itself has a thin film characteristic, and therefore, a characteristic of the insulating film 14 (e.g., a characteristic of a protective layer protecting the light emitting stack pattern 10) may be deteriorated. The reliability of the light emitting element LD may be deteriorated due to the deterioration of the characteristic of the insulating film 14.

In an embodiment, the insulating film 14 surrounding the outer circumferential surface of the light emitting stack pattern 10 has discontinuous components by disposing, on the first layer FRL, the second layer SNL configured with a material different from the material of the first layer FRL and disposing, on the second layer SNL, the third layer TIL configured with a material different from the material of the second layer SNL, so that the deterioration of the characteristic of the insulating film 14 can be reduced. Thus, the reliability of the light emitting element LD can be improved.

As described above, in the case that the insulating film configured as a multi-layer including the first layer FRL, the second layer SNL, and the third layer TIL is disposed on the outer circumferential surface (or surface) of the light emitting stack pattern 10, thereby surrounding the outer circumferential surface of the light emitting stack pattern 10, thanks to interactions between the first, second, and third layers FRL, SNL, and TIL, the surface defect of the light emitting stack pattern 10 can be easily or effectively controlled, and the protective layer characteristic of the insulating film 14 is improved. Accordingly, the reliability (or light emission efficiency) of the light emitting element LD can be improved.

The above-described light emitting element LD may be grown and manufacture on a substrate (not shown) for epitaxial growth.

The light emitting element LD may be used as a light source of various display devices. The light emitting element LD may be manufactured through a surface treatment process. For example, in the case that a plurality of light emitting elements LD are mixed in a liquid solution (or solvent) to be supplied to each pixel area (e.g., an emission area of each pixel (or each sub-pixel)), each light emitting element LD may be surface-treated such that the light emitting elements LD are not unequally condensed in the solution but equally dispersed in the solution.

An emission component including the above-described light emitting element LD may be used in various types of devices that require a light source, including a display device.

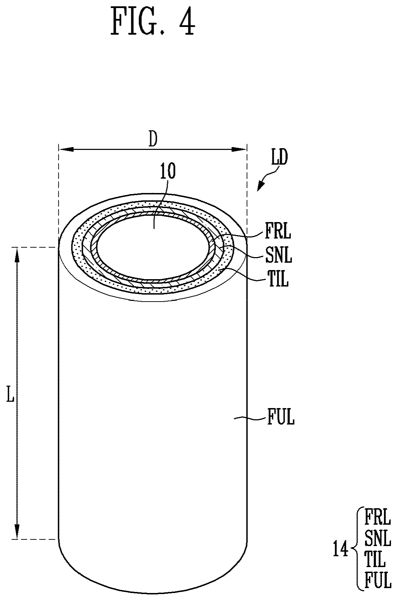

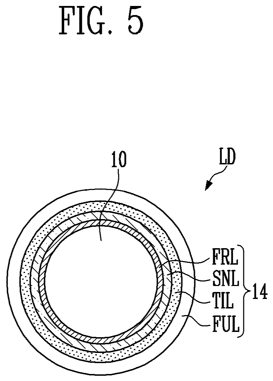

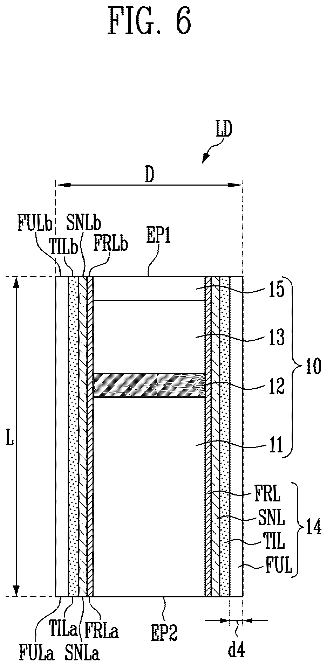

FIG. 4 is a schematic perspective view of a light emitting element LD in accordance with an embodiment of the present disclosure. FIG. 5 is a schematic view, viewed from the top of the light emitting element LD shown in FIG. 4. FIG. 6 is a schematic cross-sectional view of the light emitting element LD shown in FIG. 3.

In relation to the embodiment shown in FIGS. 4 to 6, portions different from those of the above-described embodiment will be mainly described to avoid redundancy.

Referring to FIGS. 4 to 6, the light emitting element LD may include a light emitting stack pattern 10 and an insulating film 14 surrounding an outer circumferential surface (or surface) of the light emitting stack pattern 10.

The light emitting stack pattern 10 may include a first semiconductor layer 11, an active layer 12, a second semiconductor layer 13, and an electrode layer 15, which are stacked on each other in a length direction of the light emitting element LD.

The insulating film 14 may be provided in the form of a multi-layer including at least four layers. In an embodiment, the insulating film 14 may include a first layer FRL, a second layer SNL, a third layer TIL, and a fourth layer FUL. The first layer FRL may be directly disposed on the outer circumferential surface of the light emitting stack pattern 10 to surround the light emitting stack pattern 10. The second layer SNL may be disposed on the first layer FRL to surround the first layer FRL. The third layer TIL may be disposed on the second layer SNL to surround the second layer SNL. The fourth layer FUL may be disposed on the third layer TIL to surround the third layer TIL. The first layer FRL, the second layer SNL, and the third layer TIL may be the first layer FRL, the second layer SNL, and the third layer TIL, which are described with reference to FIGS. 1 to 3.

The fourth layer FUL may be an outer circumferential surface (or surface) of the light emitting element LD. For example, the fourth layer FUL may be located at an outermost portion of a side surface of the light emitting element LD.

The fourth layer FUL may include a first surface FULa and a second FULb, which face each other in the length direction of the light emitting element LD. In a direction perpendicular to the length direction of the light emitting element LD, the first surface FULa may be located on the same line as a second end portion EP2 of the light emitting element LD, and the second surface FULb may be located on the same line as a first end portion EP1 of the light emitting element LD. However, the present disclosure is not limited thereto.

The first layer FRL and the third layer TIL may include the same material. For example, the first layer FRL and the third layer TIL may include at least one of zirconium oxide (ZrOₓ), silicon oxide (SiOₓ), hafnium oxide (HfOₓ), beryllium oxide (BeOₓ), tantalum oxide (TaₓO_{y}), aluminium oxide (AlₓO_{y}), lanthanum oxide (LaₓO_{y}), niobium oxide (NbₓO_{y}), titanium oxide (TiOₓ), cerium oxide (CeOₓ), magnesium oxide (MgOₓ), yttrium oxide (YₓO_{y}), and strontium oxide (SrₓO_{y}). Also, the first layer FRL and the third layer TIL may include at least one of aluminium nitride (AIN), hafnium nitride (HfN), zirconium nitride (ZrN), silicon nitride (SiNₓ), aluminium oxynitride (AlOₓN_{y}), hafnium oxynitride (HfOₓN_{y}), zirconium oxynitride (ZrOₓN_{y}), AlGaN, and InGaN. In an embodiment, the first layer FRL and the third layer TIL may include at least one of zirconium oxide (ZrOₓ), hafnium oxide (HfOₓ), zirconium nitride (ZrN), hafnium nitride (HfN), zirconium oxynitride (ZrOₓN_{y}), and hafnium oxynitride (HfOₓN_{y}).

The second layer SNL may be configured with a material different from the material of the above-described first and third layers FRL and TIL.

The fourth layer FUL may include an inorganic insulating material. The fourth layer FUL may be configured with a material different from the material of the above-described first and third layers FRL and TIL. Also, the fourth layer FUL may be configured with the same material as the second layer SNL or be configured with a material different from the material of the second layer SNL. The fourth layer FUL may be configured with a material different from the material of the first and third layers FRL and TIL among the materials exemplified as the material constituting the first and third layers FRL and TIL. For example, in the case that the first and third layers FRL and TIL include at least one of zirconium oxide (ZrOₓ), hafnium oxide (HfOₓ), zirconium nitride (ZrN), hafnium nitride (HfN), zirconium oxynitride (ZrOₓN_{y}), and hafnium oxynitride (HfOₓN_{y}), the fourth layer FUL may include silicon oxide (SiOₓ).

The fourth layer FUL along with the first, second, and third layers FRL, SNL, and TIL may expose each of a portion of the electrode layer 15 located at the first end portion EP1 of the light emitting element LD and a portion of the first semiconductor layer 11 located at the second end portion EP2 of the light emitting element LD.

The fourth layer FUL may have a thickness d4 relatively thicker than a thickness of each of the first to third layers FRL, SNL, and TIL. For example, the fourth layer FUL may have a thickness d4 of about 10 nm to about 40 nm, but the present disclosure is not limited thereto.

In the case that the fourth layer FUL is disposed on the third layer TIL to surround the third layer TIL, a surface defect of the light emitting stack pattern 10, which occurs in a manufacturing process, is reduced, a lattice defect existing between the light emitting stack pattern 10 and the first to third layers FRL, SNL, and TIL is further reduced, and the active layer 12 (or light emitting layer) is further prevented from being short-circuited with an external conductive material, thereby improving the reliability of the light emitting element LD.

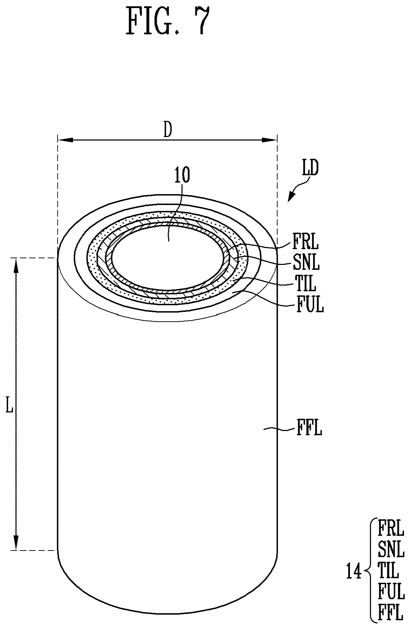

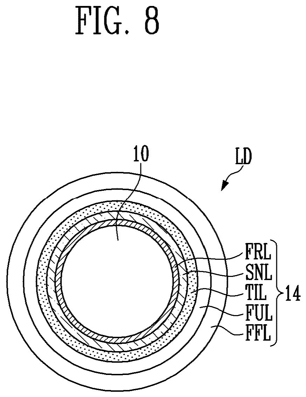

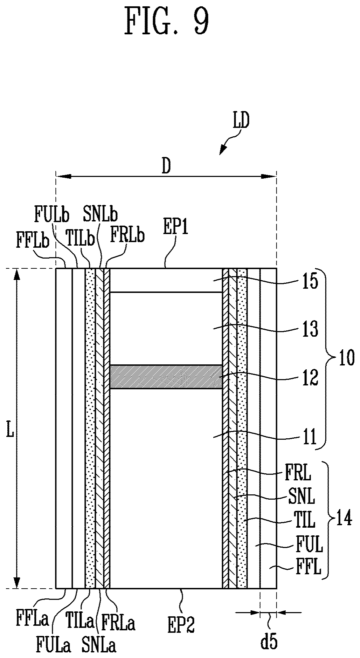

FIG. 7 is a schematic perspective view of a light emitting element LD in accordance with an embodiment of the present disclosure. FIG. 8 is a schematic view, viewed from the top of the light emitting element LD shown in FIG. 7. FIG. 9 is a schematic cross-sectional view of the light emitting element LD shown in FIG. 5.

In relation to the embodiment shown in FIGS. 7 to 9, portions different from those of the above-described embodiment will be described to avoid redundancy.

Referring to FIGS. 7 to 9, the light emitting element LD may include a light emitting stack pattern 10 and an insulating film 14 surrounding an outer circumferential surface (or surface) of the light emitting stack pattern 10.

The light emitting stack pattern 10 may include a first semiconductor layer 11, an active layer 12, a second semiconductor layer 13, and an electrode layer 15, which are stacked on each other in a length direction of the light emitting element LD.

The insulating film 14 may be provided in the form of a multi-layer including at least five layers. In an embodiment, the insulating film 14 may include a first layer FRL, a second layer SNL, a third layer TIL, a fourth layer FUL, and a fifth layer FFL. The first layer FRL may be directly disposed on the outer circumferential surface of the light emitting stack pattern 10 to surround the light emitting stack pattern 10. The second layer SNL may be disposed on the first layer FRL to surround the first layer FRL. The third layer TIL may be disposed on the second layer SNL to surround the second layer SNL. The fourth layer FUL may be disposed on the third layer TIL to surround the third layer TIL. The fifth layer FFL may be disposed on the fourth layer FUL to surround the fourth layer FUL. The first layer FRL, the second layer SNL, the third layer TIL, and the fourth layer FUL may be the first layer FRL, the second layer SNL, the third layer TIL, and the fourth layer FUL, which are described with reference to FIGS. 1 to 6.

The fifth layer FFL may be an outer circumferential surface (or surface) of the light emitting element LD. For example, the fifth layer FFL may be located at an outermost portion in a side surface of the light emitting element LD.

The fifth layer FFL may include a first surface FFLa and a second FFLb, which face each other in the length direction of the light emitting element LD. In a direction perpendicular to the length direction of the light emitting element LD, the first surface FFLa may be located on the same line as a second end portion EP2 of the light emitting element LD, and the second surface FFLb may be located on the same line as a first end portion EP1 of the light emitting element LD. However, the present disclosure is not limited thereto.

The first layer FRL and the third layer TIL may include the same material. For example, the first layer FRL and the third layer TIL may include at least one of zirconium oxide (ZrOₓ), hafnium oxide (HfOₓ), zirconium nitride (ZrN), hafnium nitride (HfN), zirconium oxynitride (ZrOₓN_{y}), and hafnium oxynitride (HfOₓN_{y}).

The second layer SNL may be configured with a material different from the material of the above-described first and third layers FRL and TIL.

The fourth layer FUL may include an inorganic insulating material. For example, the fourth layer FUL may include silicon oxide (SiOₓ).

The fifth layer FFL may include an inorganic insulating material. The fifth layer FFL may be configured with a material different from the material of the above-described first and third layers FRL and TIL. Also, the fifth layer FFL may be configured with the same material as the fourth layer FUL or be configured with a material different from the material of the fourth layer FUL. For example, the fifth layer FFL may include aluminium oxide (AlₓO_{y}).

The fifth layer FFL along with the first to fourth layers FRL, SNL, TIL, and FUL may expose each of a portion of the electrode layer 15 located at the first end portion EP1 of the light emitting element LD and a portion of the first semiconductor layer 11 located at the second end portion EP2 of the light emitting element LD.

The fifth layer FFL may have a thickness d5 relatively thicker than a thickness of each of the first to fourth layers FRL, SNL, TIL, and FUL. For example, the fifth layer FFL may have a thickness d5 of about 40 nm or thicker, but the present disclosure is not limited thereto. In some embodiments, the fifth layer FFL may have a thickness d5 substantially similar or equal to the thickness of the fourth layer FUL.

In the case that the fifth layer FFL is disposed on the fourth layer FUL to surround the fourth layer FUL, a surface defect of the light emitting stack pattern 10, which occurs in a manufacturing process, is further reduced, a lattice defect existing between the light emitting stack pattern 10 and the first to fourth layers FRL, SNL, TIL, and FUL is further reduced, and the active layer 12 (or light emitting layer) is further prevented from being short-circuited with an external conductive material, thereby further improving the reliability of the light emitting element LD.

Hereinafter, an example of a display device using the above-described light emitting element LD as a light source will be described.

FIG. 10 is a schematic plan view of a display device DD in accordance with an embodiment of the present disclosure.

In FIG. 10, for convenience of description, a structure of the display device DD, e.g., a display panel DP provided in the display device DD is briefly illustrated based on a display area DA in which an image is displayed.

Referring to FIG. 10, the display device DD may be classified into a passive matrix type display device and an active matrix type display device according to a method of driving a light emitting element LD (see "LD" shown in FIG. 1). For example, in the case that the display device DD is implemented as the active matrix type display device, each of pixels PXL may include a driving transistor for controlling an amount of current supplied to the light emitting element LD, a switching transistor for transferring a data signal to the driving transistor, and the like.

The display panel DP (or the display device DD) may include a substrate SUB and pixels PXL provided on the substrate SUB. Each of the pixels PXL may include at least one light emitting element LD.

The substrate SUB may include the display area DA and a non-display area NDA.

The display area DA may be an area in which the pixels PXL for displaying an image are provided.

The non-display area NDA may be located adjacent to the display area DA. The non-display area NDA may be provided at at least one side of the display area DA. For example, the non-display area NDA may surround a circumference (or edge) of the display area DA. A line part electrically connected to each pixel PXL and a driver which is electrically connected to the line part and drives the pixel PXL may be provided in the non-display area NDA.

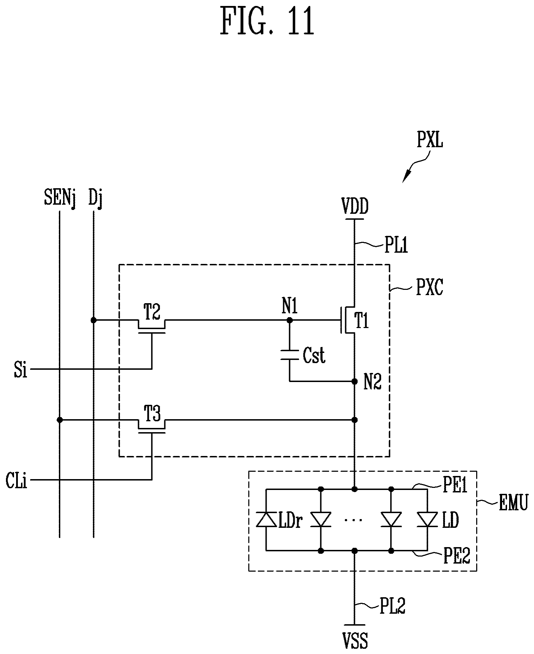

The line part may electrically connect the driver and each pixel PXL to each other. The line part may include fan-out lines. The fan-out lines may be electrically connected to each of a scan line and a data line, which are electrically connected to a pixel circuit (see "PXC" shown in FIG. 11) of each pixel PXL. Also, the fan-out lines may be electrically connected to each a control line and a sensing line, which are electrically connected to the pixel circuit PXC to compensate for an electrical characteristic change of each pixel PXL in real time.

The substrate SUB may include a transparent insulating material to enable light to transmitted therethrough. The substrate SUB may be a rigid substrate or a flexible substrate.

The rigid substrate may be, for example, at least one of a glass substrate, a quartz substrate, a glass ceramic substrate, and a crystalline glass substrate.

The flexible substrate may be at least one of a film substrate and a plastic substrate, which include a polymer organic material. For example, the flexible substrate may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

One area on the substrate SUB may be provided as the display area, so that the pixels PXL are disposed therein, and the other area on the substrate SUB may be provided as the non-display area NDA. For example, the substrate SUB may include the display area DA including pixel areas in which the respective pixels PXL are disposed and the non-display area NDA disposed at the periphery of the display area DA (or adjacent to the display area DA).

Each of the pixels PXL may be provided in the display area DA of the substrate SUB. A plurality of pixels PXL may be provided to be arranged in a matrix form along pixel rows (or pixel columns) extending in a first direction DR1 and pixel columns (or pixel rows) extending in a second direction DR2 intersecting the first direction DR1, but the arrangement structure of the pixels PXL is not limited thereto.

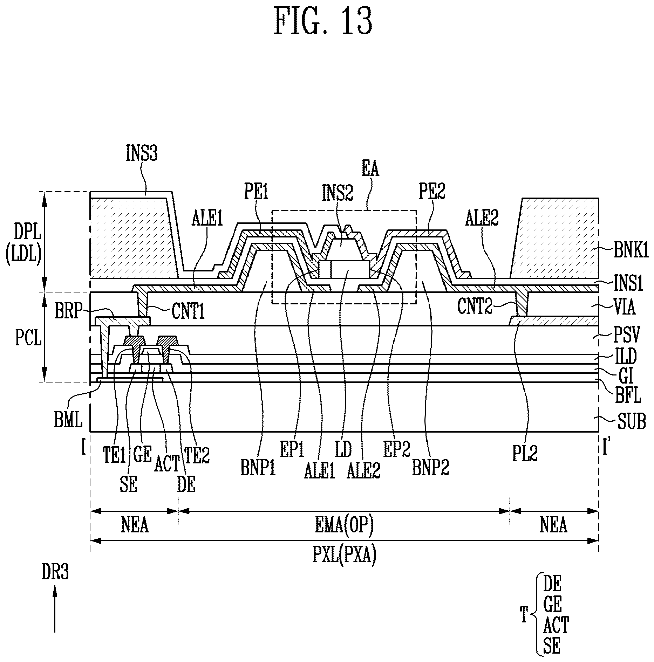

Each pixel PXL may include a pixel circuit layer (see "PCL" shown in FIG. 13) and a display element layer (see "DPL" shown in FIG. 13), which are located on the substrate SUB.

A pixel circuit PXC which is provided on the substrate SUB and includes a plurality of transistors and signal lines electrically connected to the transistors may be disposed in the pixel circuit layer PCL. Each transistor may have, for example, a form in which a semiconductor layer, a gate electrode, a first terminal, and a second terminal are stacked on each other with an insulating layer interposed therebetween. The semiconductor layer may include amorphous silicon, poly-silicon, low temperature poly-silicon, an organic semiconductor, and/or an oxide semiconductor. The semiconductor layer may include a channel region, a source region, and a drain region. The gate electrode, the first terminal, and the second terminal may include one of aluminium (Al), copper (Cu), titanium (Ti), and molybdenum (Mo), but the present disclosure is not limited thereto. Also, the pixel circuit layer PCL may include at least one insulating layer.

The display element layer DPL may be disposed on the pixel circuit layer PCL. An emission component (see "EMU" shown in FIG. 11) including at least one light emitting element LD emitting light may be located in the display element layer DPL. Electrodes electrically connected to the light emitting element LD may be disposed in the emission component EMU. Components of each pixel PXL will be described in detail later.

Each pixel PXL may include at least one light emitting element LD driven by a corresponding scan signal and a corresponding data signal. The light emitting element LD may have a size small to a degree of nano scale (or nanometer) to micro scale (or micrometer), and be connected in parallel to light emitting elements disposed adjacent thereto. However, the present disclosure is not limited thereto. The light emitting element LD may constitute a light source of each pixel PXL.

FIG. 11 is a schematic circuit diagram illustrating an electrical connection relationship of components included in each of the pixels PXL shown in FIG. 10.

For example, FIG. 11 illustrates an electrical connection relationship of components included in a pixel PXL applicable to an active matrix type display device in accordance with an embodiment of the present disclosure. However, the connection relationship of the components of each pixel PXL is not limited thereto.

Referring to FIGS. 10 and 11, the pixel PXL may include an emission component EMU which generates light with a luminance corresponding to a data signal. Also, the pixel PXL may include a pixel circuit PXC for driving the emission component EMU.

The emission component EMU may include a plurality of light emitting elements LD connected in parallel between a first power line PL1 connected to a first driving power source to be applied with a voltage of the first driving power source VDD and a second power line PL2 connected to a second driving power source VSS to be applied with a voltage of the second driving power source VSS. For example, the light emitting element EMU may include a first electrode PE1 (or first pixel electrode) connected to the first driving power source VDD via the pixel circuit PXC and the first power line PL1, a second electrode PE2 (or second pixel electrode) connected to the second driving power source VSS through the second power line PL2, and a plurality of light emitting elements LD connected in parallel in the same direction between the first and second electrodes PE1 and PE2. In an embodiment, the first electrode PE1 may be an anode electrode and the second electrode PE2 may be a cathode.

Each of the light emitting elements LD included in the emission component EMU may include one end portion (or first end portion EP1) electrically connected to the first driving power source VDD through the first electrode PE1 and the other end portion (or second end portion EP2) electrically connected to the second driving power source VSS though the second electrode PE2. The first driving power source VDD and the second driving power source VSS may have different potentials. For example, the first driving power source VDD may be set as a high-potential power source, and the second driving power source VSS may be set as a low-potential power source. A potential difference of the first and second driving power sources VDD and VSS may be set equal to or higher than a threshold voltage of the light emitting elements LD during a light emission period of the pixel PXL.

As described above, the light emitting elements connected in parallel in the same direction (e.g., a forward direction) between the first electrode PE1 and the second electrode PE2, to which voltages of different power sources are supplied, may constitute effective light sources, respectively.

The light emitting elements LD of the emission component EMU may emit light with a luminance corresponding to a driving current supplied through the corresponding pixel circuit PXC. For example, during each frame period, a driving current corresponding to a grayscale of corresponding frame data of the pixel circuit PXC may be supplied to the emission component EMU. The driving current supplied to the emission component EMU may be divided to flow through each of the light emitting elements LD. Accordingly, while each light emitting element LD emits light with a luminance corresponding to a current flowing therethrough, the emission component EMU can emit light with the luminance corresponding to the driving current.

Although an embodiment in which both end portions of the light emitting elements LD are connected in the same direction between the first and second driving power sources VDD and VSS has been described, but the present disclosure is not limited thereto. In some embodiments, the emission component EMU may further include at least one reverse light emitting element LDr, in addition to the light emitting elements LD forming the respective effective light sources. The reverse light emitting element LDr is connected in parallel together with the light emitting elements LD forming the effective light sources between the first and second electrodes PE1 and PE2, and may be connected between the first and second electrodes PE1 and PE2 in a direction opposite to that in which the light emitting elements LD are connected. Although a predetermined or selected driving voltage (e.g., a forward driving voltage) is applied between the first and second electrodes PE1 and PE2, the reverse light emitting element LDr maintains an inactivated state, and accordingly, no current substantially flows through the reverse light emitting element LDr.

The pixel circuit PXC may be electrically connected to a scan line Si and a data line Dj of the pixel PXL. Also, the pixel circuit PXC may be connected to a control line CLi and a sensing line SENj of the pixel PXL. For example, in the case that the pixel PXL is disposed on an ith row and a jth column of the display area DA, the pixel circuit PXC of the pixel PXL may be electrically connected an ith scan line Si, a jth data line Dj, an ith control line CLi, and a jth sensing line SENj of the display area DA.

The pixel circuit PXC may include first to third transistors T1 to T3 and a storage capacitor Cst.

The first transistor T1 is a driving transistor for controlling a driving current applied to the emission component EMU, and may be electrically connected between the first driving power source VDD and the emission component EMU. Specifically, a first terminal of the first transistor T1 may be connected to the first driving power source VDD through the first power line PL1, a second terminal of the first transistor T1 may be connected to a second node N2, and a gate electrode of the first transistor T1 may be connected to a first node N1. The first transistor T1 may control an amount of driving current applied to the emission component EMU through the second node N2 from the first driving power source VDD according to a voltage applied to the first node N1. In an embodiment, the first terminal of the first transistor T1 may be a drain electrode, and the second terminal of the first transistor T1 may be a source electrode. However, the present disclosure is not limited thereto. In some embodiments, the first terminal may be the source electrode, and the second terminal may be the drain electrode.

The second transistor T2 is a switching transistor which selects a pixel PXL in response to a scan signal and activates the pixel PXL, and may be electrically connected between the data line Dj and the first node N1. A first terminal of the second transistor T2 may be electrically connected to the data line Dj, a second terminal of the second transistor T2 may be electrically connected to the first node N1, and a gate electrode of the second transistor T2 may be electrically connected to the scan line Si. The first terminal and the second terminal of the second transistor T2 are different terminals. For example, in the case that the first terminal is a drain electrode, the second terminal may be a source electrode.

The second transistor T2 may be turned on in the case that the scan signal having a gate-on voltage (e.g., a high level voltage) is supplied from the scan line Si, to electrically connect the data line Dj and the first node N1 to each other. The first node N1 is a point at the second terminal of the second transistor T2 and the gate electrode of the first transistor T1 are connected to each other. The second transistor T2 may transfer a data signal to the gate electrode of the first transistor T1.

The third transistor T3 may connect the first transistor T1 to the sensing line SENj, to acquire a sensing signal through the sensing line SENj and to detect characteristics of the pixel PXL, including a threshold voltage of the first transistor T1, and the like, by using the sensing signal. Information on the characteristics of the pixel PXL may be used to convert image data such that a characteristic deviation between pixels PXL can be compensated. A second terminal of the third transistor T3 may be electrically connected to the second terminal of the first transistor T1, a first terminal of the third transistor T3 may be electrically connected to the sensing line SENj, and a gate electrode of the third transistor T3 may be electrically connected to the control line CLi. In addition, the first terminal of the third transistor T3 may be electrically connected to an initialization power source. The third transistor T3 is an initialization transistor capable of initializing the second node N2, and may be turned on in the case that a sensing control signal is supplied from the control line CLi, to transfer a voltage of the initialization power source to the second node N2. Accordingly, the storage capacitor Cst, which is electrically connected to the second node N2, can be initialized.

The storage capacitor Cst may include a first storage electrode (or lower electrode) and a second storage electrode (or upper electrode). The first storage electrode of the storage capacitor Cst may be electrically connected to the first node N1, and the second storage electrode of the storage capacitor Cst may be electrically connected to the second node N2. The storage capacitor Cst charges a data voltage corresponding to the data signal supplied to the first node N1 during one frame period. Accordingly, the storage capacitor Cst can store a voltage corresponding to a difference between a voltage of the gate electrode of the first transistor T1 and a voltage of the second node N2.

Although an embodiment in which the light emitting elements LD constituting the emission component EMU are all connected in parallel has been illustrated in FIG. 11, the present disclosure is not limited thereto. In some embodiments, the emission component EMU may be configured to include at least one serial stage including a plurality of light emitting elements LD connected in parallel to each other. For example, the emission component EMU may be configured in a series/parallel hybrid structure.

Although an embodiment in which the first to third transistors T1, T2, and T3 included in the pixel circuit PXC are all N-type transistors is disclosed in FIG. 11, the present disclosure is not limited thereto. For example, at least one of the first to third transistors T1, T2, and T3 may be replaced with a P-type transistor. Also, although an embodiment in which the emission component EMU is connected between the pixel circuit PXC and the second driving power source VSS is disclosed in FIG. 11, the emission component EMU may be connected between the first driving power source VDD and the pixel circuit PXC.

The structure of the pixel circuit PXC may be variously modified and embodied. For example, the pixel circuit PXC may additionally further include at least one transistor element such as a transistor element for initializing the first node N1 and/or a transistor element for controlling an emission time of the light emitting elements LD, or other circuit elements such as a boosting capacitor for boosting a voltage of the first node N1.

In the following embodiment, for convenience of description, a lateral direction (or X-axis direction) on a plane is represented as a first direction DR1, a longitudinal direction (or Y-axis direction) on the plane is represented as a second direction DR2, and a longitudinal direction on a section is represented as a third direction DR3.

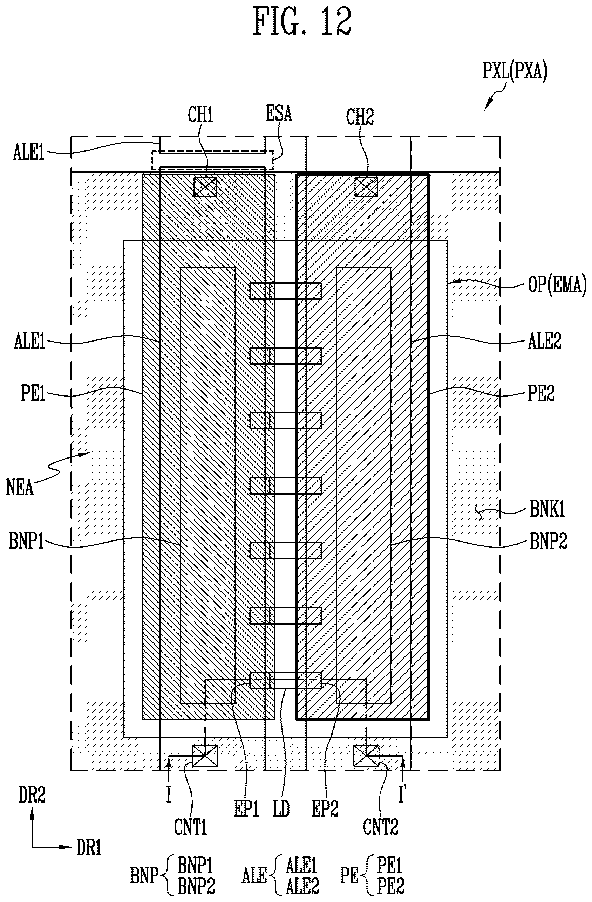

FIG. 12 is a schematic plan view illustrating a pixel PXL in accordance with an embodiment of the present disclosure.

Referring to FIGS. 10 to 12, the pixel PXL may be located in a pixel area PXA prepared (or provided) in the display area DA of the substrate SUB. The pixel area PXA may include an emission area EMA and a non-emission area NEA.

The pixel PXL may include a first bank BNK1 located in the non-emission area NEA and light emitting elements LD located in the emission area EMA.

The first bank BNK1 is a structure defining (or partitioning) a pixel area PXA (or an emission area EMA) of each of the pixel PXL and adjacent pixels PXL adjacent thereto, and may be, for example, a pixel defining layer.

In an embodiment, the first bank BNK1 may be a structure defining each emission area EMA to which light emitting elements LD are to be supplied in a process of supplying (or inputting) the light emitting elements LD to the pixel PXL. For example, the emission area EMA of the pixel PXL is partitioned by the first bank BNK1, so that a mixed liquor (e.g., an ink) including a desired quantity and/or a desired kind of light emitting elements LD can be supplied to the emission area EMA.

The first bank BNK1 may include at least one light blocking material and/or at least one reflective material (or light scattering material), to prevent a light leakage defect in which light is leaked between the pixel PXL and adjacent pixels PXL adjacent thereto. In some embodiments, the first bank BNK1 may include a transparent material (or substance). The transparent material may include, for example, polyamide resin, polyimide resin, and the like, but the present disclosure is not limited thereto. In another embodiment, a reflective material layer may be separately provided and/or formed on the first bank BNK1 so as to further improve the efficiency of light emitted from the pixel PXL.

The first bank BNK1 may include at least one opening OP exposing components located thereunder in the pixel area PXA. In an embodiment, the emission area EMA of the pixel PXL and the opening OP of the first bank BNK1 may correspond to each other.

An electrode separation area ESA may be located in a non-emission area NEA of each pixel PXL. The electrode separation area ESA may be an area in which a first alignment electrode ALE1 in each pixel PXL is separated from a first alignment electrode ALE1 provided in a pixel PXL adjacent in the second direction DR2.

The pixel PXL may include electrodes PE provided in at least the emission area EMA, light emitting elements LD electrically connected to the electrodes PE, alignment electrodes ALE provided at positions corresponding to the electrodes PE, and bank patterns BNP. For example, the pixel PXL may include first and second electrodes PE1 and PE2 provided in at least the emission area EMA, light emitting elements LD, first and second alignment electrodes ALE1 and ALE2, and first and second bank patterns BNP1 and BNP2. The number, shape, size, arrangement structure, and the like of each of the electrodes PE and/or the alignment electrodes ALE may be variously changed according to a structure of the pixel PXL (e.g., an emission component EMU).

In an embodiment, the bank patterns BNP, the alignment electrodes ALE, the light emitting elements LD, and the electrodes PE may be sequentially provided with respect to one surface of the substrate SUB, on which the pixel PXL is provided, but the present disclosure is not limited thereto. In some embodiments, the positions and formation order of electrode patterns constituting the pixel PXL (or the emission component EMU) may be variously changed. A stacked structure (or sectional structure) of the pixel PXL will be described later with reference to FIGS. 13 to 15.

The bank patterns BNP may be provided in at least the emission area EMA, and be spaced apart from each other in the first direction DR1 in the emission area EMA. Each of the bank patterns BNP may extend along the second direction DR2. The bank patterns BNP may include the first bank pattern BNP1 and the second bank pattern BNP2, which are arranged to be spaced apart from each other in the first direction DR1.

Each bank pattern BNP (also, referred to as a "wall pattern," a "protrusion pattern," a "support pattern," or a "wall structure") may have a uniform width in the emission area EMA. Each of the first and second bank patterns BNP1 and BNP2 may have a bar-like shape having a predetermined width along an extending direction thereof in the emission area EMA when viewed on a plane, but the present disclosure is not limited thereto.

The bank pattern BNP may support each of the first and second alignment electrodes ALE1 and ALE2 to change a surface profile (or shape) of each of the first and second alignment electrodes ALE1 and ALE2 such that light emitted from the light emitting elements LD is guided in an image display direction (or front direction) of the display device DD.

The bank patterns BNP may have the same width or different widths. For example, the first and second bank patterns BNP1 and BNP2 may have the same width or different widths in the first direction DR1 in at least the emission area EMA.

Each of the first and second bank patterns BNP1 and BNP2 may partially overlap with a corresponding alignment electrode ALE in at least the emission area EMA. For example, the first bank pattern BNP1 may be located on the bottom of the first alignment electrode ALE1 to overlap with one area of the first alignment electrode ALE1, and the second bank pattern BNP2 may be located on the bottom of the second alignment electrode ALE2 to overlap with one area of the second alignment electrode ALE2. The bank pattern BNP along with the alignment electrode ALE may be a structure accurately defining an alignment position of the light emitting elements LD in the emission area EMA of the pixel PXL.

As the bank pattern BNP is provided on the bottom of one area of each of the alignment electrodes ALE in the emission area EMA, the one area of each of the alignment electrodes ALE may protrude in an upper direction of the pixel PXL in an area in which the bank pattern BNP is formed. Accordingly, the bank patterns BNP as wall structures may be formed at the periphery of the light emitting elements LD. For example, wall structures may be formed in the emission area EMA to face first and second end portions EP1 and EP2 of the light emitting elements LD.

In an embodiment, in the case that the bank pattern BNP and/or the alignment electrode ALE include/includes a reflective material, reflective wall structures may be formed at the periphery of the light emitting elements LD. Accordingly, while light emitted from the light emitting elements LD faces in the upper direction of the pixel PXL (or the image display direction), the light emission efficiency of the pixel PXL can be further improved.

The alignment electrodes ALE may be located in at least the emission area EMA, and be spaced apart from each other in the first direction DR1 in the emission area EMA. Each of the alignment electrodes ALE may extend in the second direction DR2. The alignment electrodes ALE may include a first alignment electrode ALE1 and a second alignment electrode ALE2, which are arranged to be spaced part from each other in the first direction DR1 and extend in the second direction DR2.

At least one of the first and second alignment electrodes ALE1 and ALE2 may be separated from another electrode (e.g., an alignment electrode ALE provided in an adjacent pixel adjacent to each pixel PXL in the second direction DR2) after the light emitting elements LD are supplied and aligned in the emission area EMA in a manufacturing process of the display device DD. For example, the first alignment electrode ALE1 may be separated from a first alignment electrode ALE1 provided in an adjacent pixel PXL adjacent to the corresponding pixel PXL after the light emitting elements LD are supplied and aligned in the emission area EMA in the manufacturing process of the display device DD.

The first alignment electrode ALE1 may be electrically connected to the storage capacitor Cst of the pixel circuit PXC described with reference to FIG. 11 through a first contact part CNT1. The first contact part CNT1 may be formed by opening one area of an insulating layer located between the first alignment electrode ALE1 and the storage capacitor Cst. The second alignment electrode ALE2 may be electrically connected to a second power line (see "PL2" shown in FIG. 11) electrically connected to the pixel circuit PXC through a second contact part CNT2. The second contact part CNT2 may be formed by opening one area of an insulating layer located between the second alignment electrode ALE2 and the second power line PL2.

The first contact part CNT1 and the second contact part CNT2 may be located in the non-emission area NEA to overlap with the first bank BNK1, but the present disclosure is not limited thereto. In some embodiments, both the first contact part CNT1 and the second contact part CNT2 may be located in the emission area EMA. Alternatively, one of the first contact part CNT1 and the second contact part CNT2 may be located in the non-emission area NEA, and the other of the first contact part CNT1 and the second contact part CNT2 may be located in the emission area EMA.

Each of the first alignment electrode ALE1 and the second alignment electrode ALE2 may be supplied a predetermined or selected alignment signal in an alignment process of the light emitting elements LD. For example, the first alignment electrode ALE1 may be supplied with a first alignment signal in the alignment process of the light emitting elements LD, and the second alignment electrode ALE2 and the other second alignment electrode ALE2 may be supplied with a second alignment signal in the alignment process of the light emitting elements LD. The first and second alignment signals may be signals having a voltage difference and/or a phase difference to a degree to which the light emitting elements LD can be aligned between the alignment electrodes ALE. At least one of the first and second alignment signals may be an AC signal, but the present disclosure is not limited thereto.

At least two light emitting elements LD may be aligned and/or provided in the emission area EMA (or the pixel area PXA).

Light emitting elements LD may be disposed between the first alignment electrode ALE1 and the second alignment electrode ALE2. When viewed on a plane, each of the light emitting elements LD may include a first end portion EP1 and a second end portion EP2, which are located at both ends (or face each other) in a length direction thereof, e.g., the first direction DR1. In an embodiment, an electrode layer (see "15" shown in FIG. 3) in ohmic contact with a second semiconductor layer (see "13" shown in FIG. 3) including a p-type semiconductor layer may be located at the first end portion EP1 (or p-type end portion), and a first semiconductor layer (see "11" shown in FIG. 3) including an n-type semiconductor layer may be located at the second end portion EP2 (or n-type end portion).

The light emitting elements LD may be disposed to be spaced apart from each other, and be aligned in substantially parallel to each other. The distance at which the light emitting elements LD are spaced apart from each other is not particularly limited. In some embodiments, a plurality of light emitting elements LD may disposed adjacent to each other to form a group, and another plurality of light emitting elements LD may form a group in a state in which the another plurality of light emitting elements LD are spaced apart from each other at a certain distance. The light emitting elements LD have a density which is not uniform, but may be aligned in one direction.

The light emitting elements LD may be supplied to the pixel area PXA (or the emission area EMA) through an inkjet printing process, a slit coating process, or other various processes. For example, the light emitting elements LD may be mixed in a volatile solvent to be supplied to the pixel area PXA through the inkjet printing process or the slit coating process. In the case that an alignment signal corresponding to each of the first alignment electrode ALE1 and the second alignment electrode ALE2 is applied, an electric field may be formed between the first alignment electrode ALE1 and the second alignment electrode ALE2. Therefore, the light emitting elements LD may be aligned between first alignment electrode ALE1 and the second alignment electrode ALE2. After the light emitting element LD is aligned, a solvent may be volatilized or removed through another process, so that the light emitting elements LD can be stably aligned between first alignment electrode ALE1 and the second alignment electrode ALE2.

The electrodes PE (or pixel electrodes) may be provided in at least the emission area EMA, and each be provided at a position corresponding to at least one alignment electrode ALE and at least one light emitting element LD. For example, each electrode PE may be formed on each alignment electrode ALE and corresponding light emitting elements LD to overlap with the alignment electrode ALE and the corresponding light emitting elements LD. Therefore, the electrode PE may be electrically connected to at least the light emitting elements LD.

The electrodes PE may include a first electrode PE1 and a second electrode PE2, which are disposed to be spaced apart from each other.

The first electrode PE1 ("first pixel electrode" or "anode") may be formed on the first alignment electrode ALE1 and a first end portion EP1 of each of the light emitting elements LD, to be electrically connected to the first end portion EP1 of each of the light emitting elements LD. Also, the first electrode PE1 may be in direct contact with the first alignment electrode ALE1 through a first contact hole CH1 in at least the non-emission area NEA, thereby being electrically and/or physically connected to the first alignment electrode ALE1. The first contact hole CH1 may be formed by removing a portion of at least one insulating layer located between the first electrode PE1 and the first alignment electrode ALE1. A portion of the first alignment electrode ALE1 may be exposed by the first contact hole CH1.

The pixel circuit PXC, the first alignment electrode ALE1, and the first electrode PE1 may be electrically connected to each other through the first contact part CNT1 and the first contact hole CH1.

In the above-described embodiment, it has been described that the first alignment electrode ALE1 and the first electrode PE1 are connected to each other while being in direct contact with each other through the first contact hole CH1. However, the present disclosure is not limited thereto. In some embodiments, in order to prevent a failure caused by a material characteristic of the first alignment electrode ALE1, the first electrode PE1 is not in direct contact with the first alignment electrode ALE1 but may be in direct contact with the pixel circuit PXC, thereby being electrically connected to the pixel circuit PXC.

The first electrode PE1 may have a bar-like shape extending along the second direction DR2, but the present disclosure is not limited thereto. The shape of the first electrode PE1 may be variously changed within a range in which the first electrode PE1 is electrically and/or physically stably connected to the first end portions EP1 of the light emitting element LD. Also, the shape of the first electrode PE1 may be variously changed by considering a disposition, a connection relationship, and the like of the first electrode PE1 with the first alignment electrode ALE1 disposed thereunder.

The second electrode PE2 ("second pixel electrode" or "cathode") may be formed on the second alignment electrode ALE2 and a second end portion of each of the light emitting elements LD to be electrically connected to the second end portion EP2 of each of the light emitting elements LD. Also, the second electrode PE2 may be in direct contact with the second alignment electrode ALE2 through a second contact hole CH2, thereby being electrically and/or physically connected to the second alignment electrode ALE2. The second contact hole CH2 may be formed by removing a portion of at least one insulating layer located between the second electrode PE2 and the second alignment electrode ALE2. A portion of the second alignment electrode ALE2 may be exposed by the second contact hole CH2.

The second power line PL2, the second alignment electrode ALE2, and the second electrode PE2 may be electrically connected to each other through the second contact part CNT2 and the second contact hole CH2.

In the above-described embodiment, it has been described that the second alignment electrode ALE2 and the second electrode PE2 are connected to each other while being in direct contact with each other through the second contact hole CH2. However, the present disclosure is not limited thereto. In some embodiments, in order to prevent a failure caused by a material characteristic of the second alignment electrode ALE2, the first electrode PE1 is not in direct contact with the second alignment electrode ALE2 but may be in direct contact with the second power line PL2, thereby being electrically connected to the second power line PL2.

The second electrode PE2 may have a bar-like shape extending along the second direction DR2, but the present disclosure is not limited thereto. The shape of the second electrode PE2 may be variously changed within a range in which the second electrode PE1 is electrically and/or physically stably connected to the second end portions EP2 of the light emitting element LD. Also, the shape of the second electrode PE2 may be variously changed by considering a disposition, a connection relationship, and the like of the second electrode PE2 with the second alignment electrode ALE2 disposed thereunder.

Hereinafter, a stacked structure (or sectional structure) of the pixel PXL in accordance with the above-described embodiment will be described with reference to FIGS. 13 to 15.

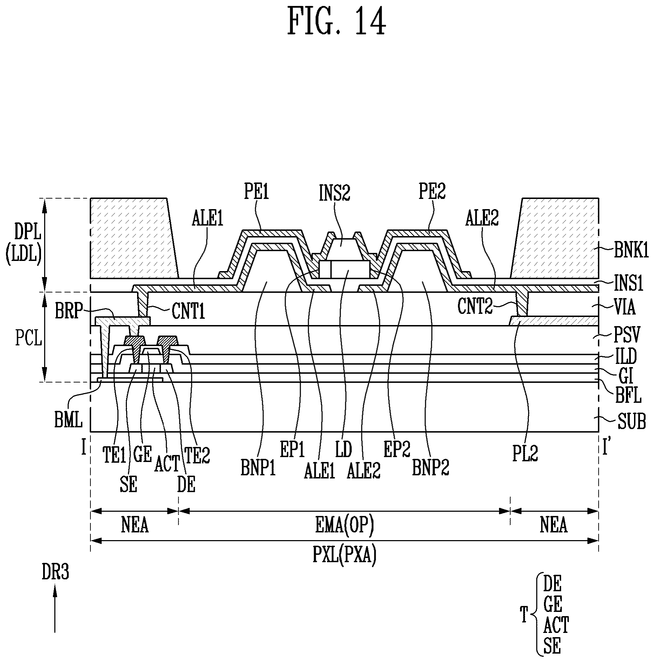

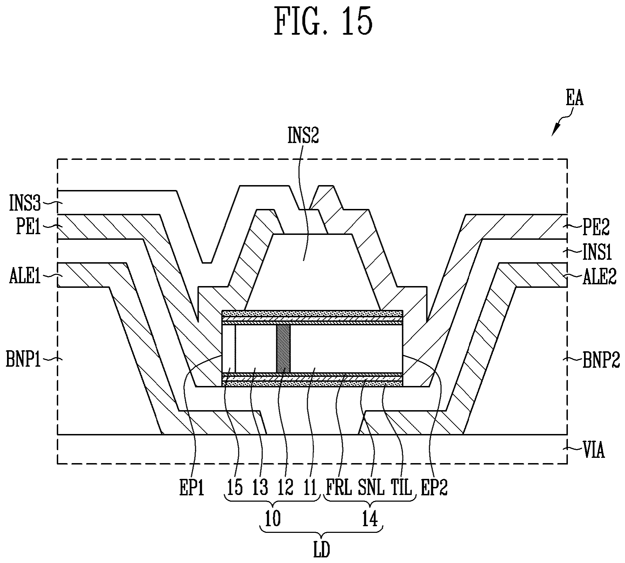

FIGS. 13 and 14 are schematic cross-sectional views taken along line I-I' shown in FIG. 12. FIG. 15 is a schematic enlarged view illustrating portion EA shown in FIG. 13.

FIG. 14 illustrates a modified example of an embodiment shown in FIG. 13 in relation to a forming process of first and second electrodes PE1 and PE2 and existence of an third insulating layer INS3. For example, an embodiment in which the first electrode PE1 and the second electrode PE2 are formed through the same process and the third insulating layer INS3 is omitted is illustrated in FIG. 14.

In embodiments shown in FIGS. 13 to 15, the stacked structure (or sectional structure) of the pixel PXL is simplified and illustrated, such as that each electrode is illustrated as an electrode having a signal layer and each insulating layer is illustrated as an insulating layer provided as a single layer, but the present disclosure is not limited thereto.

In relation to the embodiments shown in FIGS. 13 to 15, portions different from those of the above-described embodiment will be mainly described to avoid redundancy.

Referring to FIGS. 10 to 15, the pixel PXL may include the substrate SUB, a pixel circuit layer PCL, and a display element layer DPL.

The pixel circuit layer PCL and the display element layer DPL may be disposed on one surface of the substrate SUB to overlap with each other. For example, the display area DA of the substrate SUB may include the pixel circuit layer PCL disposed on the one surface of the substrate SUB and the display element layer DPL disposed on the pixel circuit layer PCL. However, the mutual positions of the pixel circuit layer PCL and the display element DPL on the substrate SUB may vary in some embodiments. In the case that the pixel circuit layer PCL and the display element layer DPL are provided as separate layers and overlap with each other, a layout space for forming each of the pixel circuit PXC and the emission component EMU on a plane can be sufficiently secured.

The substrate SUB may include a transparent insulating material to allow light to be transmitted therethrough. The substrate SUB may be a rigid substrate or a flexible substrate.

Circuit elements constituting a pixel circuit PXC of a corresponding pixel PXL and predetermined or selected signal lines electrically connected to the circuit elements may be disposed in each pixel area PXA of the pixel circuit layer PCL. In addition, alignment electrodes ALE, light emitting elements LD, and/or electrodes PE, which constitute an emission component EMU of the corresponding pixel PXL may be disposed in each pixel area PXA of the display element layer DPL.

The pixel circuit layer PCL may include at least one insulating layer in addition to the circuit elements and the signal lines. For example, the pixel circuit layer PCL may include a buffer layer BFL, a gate insulating layer GI, an interlayer insulating layer ILD, a passivation layer PSV, and a via layer VIA, which are stacked on each other on the substrate SUB along the third direction DR3.

The buffer layer BFL may be entirely disposed on the substrate SUB. The buffer layer BFL may prevent an impurity from being diffused into transistors T included in the pixel circuit PXC. The buffer layer BFL may be an inorganic insulating layer including an inorganic material. For example, the buffer layer BFL may include at least one of silicon nitride (SiNₓ), silicon oxide (SiOₓ), silicon oxynitride (SiOₓN_{y}), and aluminium oxide (AlOₓ), but the present disclosure is not limited thereto. The buffer layer BFL may be provided as a single layer, but may also be provided as a multi-layer including at least two layers. In the case that the buffer layer BFL is provided as the multi-layer, the layers may be formed of the same material or be formed of different materials. The buffer layer BFL may be omitted according to a material of the substrate SUB, a process condition, and the like.

The gate insulating layer GI may be entirely disposed on the buffer layer BFL. The gate insulating layer GI may include the same material as the above-described buffer layer BFL, or include an appropriate (or selected) material among the materials exemplified as the material constituting the buffer layer BFL. For example, the gate insulating layer GI may be an inorganic insulting layer including an inorganic material.

The interlayer insulating layer ILD may be entirely provided and/or formed on the gate insulating layer GI. The interlayer insulating layer ILD may include the same material as the buffer layer BFL, or include an appropriate (or selected) material among the materials exemplified as the material constituting the buffer layer BFL.

The passivation layer PSV may be entirely provided and/or formed on the interlayer insulating layer ILD. The passivation layer PSV may include the same material as the buffer layer BFL, or include an appropriate (or selected) material among the materials exemplified as the material constituting the buffer layer BFL.

The via layer VIA may be entirely provided and/or formed on the passivation layer PSV. The via layer VIA may be an inorganic insulating layer including an inorganic material or an organic insulating layer including an organic material. The inorganic insulating layer may include, for example, at least one of silicon oxide (SiOₓ), silicon nitride (SiNₓ), silicon oxynitride (SiOₓN_{y}), and aluminium oxide (AlOₓ). The organic insulating layer may include, for example, at least one of acrylic resin, epoxy resin, phenolic resin, polyamide resin, polyimide resin, unsaturated polyester resin, poly-phenylene ether resin, poly-phenylene sulfide resin, and benzocyclobutene resin.

The via layer VIA may be used as a planarization layer which reduces a step difference caused by components of the pixel circuit PXC, which are located thereunder in the pixel circuit layer PCL.

The pixel circuit layer PCL may include at least one conductive layer disposed between the above-described insulating layers. For example, the pixel circuit layer PCL may include a first conductive layer disposed between the substrate SUB and the buffer layer BFL, a second conductive layer disposed on the gate insulating layer GI, a third conductive layer disposed on the interlayer insulating layer ILD, and a fourth conductive layer disposed on the passivation layer PSV. However, the insulating layers and the conductive layers are not limited to the above-described embodiment. In some embodiments, another insulating layer and another conductive layer may be provided in the pixel circuit layer PCL, in addition to the insulating layers and the conductive layers.

The first conductive layer may be formed in a single layer including one selected from the group consisting of copper (Cu), molybdenum (Mo), tungsten (W), aluminium neodymium (AINd), titanium (Ti), aluminium (Al), silver (Ag), and any alloy thereof or a mixture thereof. Also, the first conductive layer may be formed in a double- or multi-layer structure including molybdenum (Mo), titanium (Ti), copper (Cu), aluminium (Al) or silver (Ag), which is a low-resistance material so as to decrease wiring resistance. Each of the second to fourth conductive layers may include the same material as the first conductive layer, or include at least one appropriate material among the materials exemplified as the material constituting the first conductive layer. However, the present disclosure is not limited thereto.

The pixel circuit PXC disposed in the pixel circuit layer PCL may include at least one transistor T. The transistor T may include one of the first, second, and third transistors T1, T2, and T3 described with reference to FIG. 11. For example, the transistor T may be the first transistor T1 described with reference to FIG. 11.

The transistor T may include a semiconductor pattern and a gate electrode GE overlapping with at least a portion of the semiconductor pattern. The semiconductor pattern may include a channel region ACT, a first contact region SE (or second terminal), and a second contact region DE (or first terminal). The first contact region SE may be a source region, and the second contact region DE may be a drain region.

The gate electrode GE may be provided and/or formed on the gate insulating layer GI to correspond to the channel region ACT of the semiconductor pattern. For example, the gate electrode GE may be the second conductive layer located between the gate insulating layer GI and the interlayer insulating layer ILD. The gate electrode GE may be provided on the gate insulating layer GI to overlap with the channel region ACT of the semiconductor pattern.

The semiconductor pattern may be provided and/or formed on the buffer layer BFL. The channel region ACT, the first contact region SE, and the second contact region DE may correspond to a semiconductor pattern made of poly-silicon, amorphous silicon, an oxide semiconductor, or the like. The channel region ACT, the first contact region SE, and the second contact region DE may be formed of a semiconductor layer undoped or doped with an impurity. For example, the first contact region SE and the second contact region DE may be formed of a semiconductor layer doped with the impurity, and the channel region ACT may be formed of a semiconductor layer undoped with the impurity. The impurity may include, for example, an n-type impurity, but the present disclosure is not limited thereto.

The channel region ACT may overlap with the gate electrode GE of the transistor T.

The first contact region SE (or second terminal) of the transistor T may be connected to one end of the channel region ACT, and be electrically connected to a bridge pattern BRP through a first connection member TE1. The second contact region DE (or first terminal) of the transistor T may be connected to the other end of the channel region ACT, and be electrically connected to a second connection member TE2.

The first connection member TE1 may be provided and/or formed on the interlayer insulating layer ILD. For example, the first connection member TE1 may be configured with the third conductive layer. One end of the first connection member TE1 may be electrically and/or physically connected to the first contact region SE of the transistor T through a contact hole sequentially penetrating the interlayer insulating layer ILD and the gate insulating layer GI. In addition, the other end of the first connection member TE1 may be electrically and/or physically connected to the bridge pattern BRP through a contact hole penetrating the passivation layer PSV located on the interlayer insulating layer ILD.

The bridge pattern BRP may be provided and/or formed on the passivation layer PSV. For example, the bridge pattern BRP may be configured with the fourth conductive layer. One end of the bridge pattern BRP may be connected to the first contact region SE of the transistor T through the first connection member TE1. In addition, the other end of the bridge pattern BRP may be electrically and/or physically connected to a bottom metal layer BML through a contact hole sequentially penetrating the passivation layer PSV, the interlayer insulating layer ILD, the gate insulating layer GI, and the buffer layer BFL. The bottom metal layer BML and the first contact region SE of the transistor T may be electrically connected to each other through the bridge pattern BRP and the first connection member TE1.

In some embodiments, the bridge pattern BRP may be electrically connected to some components, e.g., a first alignment electrode ALE1 of the display element layer DPL through a contact hole penetrating the via layer VIA.

The bottom metal layer BML may be the first conductive layer provided on the substrate SUB. The bottom metal layer BML may be electrically connected to the transistor T, to widen a driving range of a predetermined or selected voltage supplied to the gate electrode GE of the transistor T. For example, the bottom metal layer BML may be electrically connected to the first contact region SE of the transistor T, to stabilize the channel region ACT of the transistor T. In addition, as the bottom metal layer BML is electrically connected to the first contact region SE of the transistor T, floating of the bottom metal layer BML can be prevented.

The second connection member TE2 may be provided and/or formed on the interlayer insulating layer ILD. For example, the second connection member TE2 may be the third conductive layer. One end of the second connection member TE2 may be electrically and/or physically connected to the second contact region DE of the transistor T through a contact hole penetrating the interlayer insulating layer ILD and the gate insulating layer GI.

In the above-described embodiment, a case where the transistor T is a thin film transistor having a top-gate structure has been described. However, the present disclosure is not limited thereto, and the structure of the transistor T may be variously modified.

The passivation layer PSV may be provided and/or formed over the transistor T and the first and second connection members TE1 and TE2.

The pixel circuit layer PCL may include a predetermined or selected power line provided and/or formed on the passivation layer PSV. For example, the pixel circuit layer PCL may include a second power line PL2 disposed on the passivation layer PSV. The second power line PL2 may be configured with the fourth conductive layer. The voltage of the second driving power source VSS may be applied to the second power line VSS. Although a case where the second power line PL2 is disposed on the passivation layer PSV has been described, the present disclosure is not limited thereto. In some embodiments, the second power line PL2 may be disposed on an insulating layer different from the passivation layer among the insulating layers included in the pixel circuit layer PCL.

The via layer VIA may be provided and/or formed over the bridge pattern BRP and the second power line PL2. The via layer VIA may be partially opened to include a first contact part CNT1 exposing a portion of the bridge pattern BRP and a second contact part CNT2 exposing a portion of the second power line PL2.

The display element layer DPL may be disposed on the via layer VIA. The display element layer DPL may include a light emitting element layer LDL including a light emitting element LD emitting light.

The light emitting element layer LDL may include first and second bank patterns BNP1 and BNP2, first and second alignment electrodes ALE1 and ALE2, a first bank BNK1, the light emitting element LD, and first and second electrodes PE1 and PE2.

The first and second bank patterns BNP1 and BNP2 may be located on the via layer VIA. For example, the first and second bank patterns BNP1 and BNP2 may protrude in the third direction DR3 on one surface of the via layer VIA. One area of each of the first and second alignment electrodes ALE1 and ALE2 disposed on the first and second bank patterns BNP1 and BNP2 may protrude in the third direction DR3 (or a thickness direction of the substrate SUB).

The first and second bank patterns BNP1 and BNP2 may include an inorganic insulating layer including an inorganic material or an organic insulating layer including an organic material. In some embodiments, the first and second bank patterns BNP1 and BNP2 may include a single-layered organic insulating layer and/or a single-layered inorganic insulating layer, but the present disclosure is not limited thereto. In some embodiments, the first and second bank patterns BNP1 and BNP2 may be provided in the form of a multi-layer in which at least one organic insulating layer and at least one inorganic insulating layer are stacked. However, the material of the first and second bank patterns BNP1 and BNP2 is not limited to the above-described embodiment. In some embodiments, the first and second bank patterns BNP1 and BNP2 may include a conductive material (or substance).

The first bank pattern BNP1 may be located on the bottom of the first alignment electrode ALE1 in the emission area EMA, thereby overlapping with the first alignment electrode ALE1. The second bank pattern BNP2 may be located on the bottom of the second alignment electrode ALE2 in the emission area EMA, thereby overlapping with the second alignment electrode ALE2.

The first and second bank patterns BNP1 and BNP2 may have a section with a trapezoidal shape of which width is narrowed as approaching the top thereof along the third direction DR3 from the one surface (or top surface) of the via layer VIA, but the present disclosure is not limited thereto.

Each of the first and second bank patterns BNP1 and BNP2 may be used as a reflective member. For example, each of the first and second bank patterns BNP1 and BNP2 along with the alignment electrodes ALE disposed on the top thereof may be used as a reflective member which guides light emitted from each light emitting element LD in the image display direction of the display device DD, thereby improving the light emission efficiency of the pixel PXL.

The first and second alignment electrodes ALE1 and ALE2 may be located on the first and second bank patterns BNP1 and BNP2 and the via layer VIA.

The first and second alignment electrodes ALE1 and ALE2 may be disposed on the same plane, and have the same thickness in the third direction DR3. The first and second alignment electrodes ALE1 and ALE2 may be simultaneously formed through the same process or be formed consecutively.

The first and second alignment electrodes ALE1 and ALE2 may be configured with a material having reflectivity to allow light emitted from the light emitting elements LD to advance in the image display direction (or front direction) of the display device DD. For example, the first and second alignment electrodes ALE1 and ALE2 may be made of a conductive material (or substance). The conductive material may include an opaque metal suitable for reflecting light emitted from the light emitting elements LD in the image display direction of the display device DD.

Each of the first and second alignment electrodes ALE1 and ALE2 may be formed as a single layer, but the present disclosure is not limited thereto. In some embodiments, each of the first and second alignment electrodes ALE1 and ALE2 may be provided and/or formed as a multi-layer in which at least two materials among metals, alloys, conductive oxide, and conductive polymers are stacked. Each of the first and second alignment electrodes ALE1 and ALE2 may be formed as a multi-layer including at least two layers so as to minimize distortion caused by a signal delay in the case that a signal is transferred to both end portions, e.g., first and second end portions EP1 and EP2 of each of the light emitting elements LD.

In the case that the first and second alignment electrodes ALE1 and ALE2 are configured with a conductive material having reflectivity, light emitted from the first and second end portions EP1 and EP2 of each of the light emitting elements LD may further advance in the image display direction of the display device DD.

A first insulating layer INS1 may be disposed over the first and second alignment electrodes ALE1 and ALE2.

The first insulating layer INS1 may be disposed on the alignment electrodes ALE and the via layer VIA. The first insulating layer INS1 may be partially opened to expose components located thereunder in at least the non-emission area NEA. For example, the first insulating layer INS1 may be partially opened to include the first contact hole CH1 exposing one area of the first alignment electrode ALE1 as one area is removed in at least the non-emission area NEA and the second contact hole CH2 exposing one are of the second alignment electrode ALE2 as another area is removed in at least the non-emission area.

The first insulating layer INS1 may be formed as an inorganic insulating layer made of an inorganic material. The first insulating layer INS1 may be provided as a single layer or a multi-layer. In the case that the first insulating layer INS1 is provided as the multi-layer, the first insulating layer INS1 may be provided in a distributed bragg reflector structure in which a first inorganic layer and a second inorganic layer, which have different refractive indices, are alternately stacked.

The first insulating layer INS1 may be entirely disposed throughout the emission area EMA and the non-emission area NEA of each pixel PXL, but the present disclosure is not limited thereto. In some embodiments, the first insulating layer INS1 may be located in only a specific area, e.g., the emission area EMA of each pixel PXL.

The first bank BNK1 may be located on the first insulating layer INS1.

The first bank BNK1 may be disposed on the first insulating layer INS1 in the non-emission area NEA. The first bank BNK1 may be a pixel defining layer formed between adjacent pixels PXL to surround an emission area EMA of each pixel PXL, thereby partitioning (or defining) the emission area EMA of the corresponding pixel PXL.

The first bank BNK1 and the first and second bank patterns BNP1 and BNP2 may be formed through different processes to be provided in different layers, but the present disclosure is not limited thereto. In some embodiments, the first bank BNK1 and the first and second bank patterns BNP1 and BNP2 are formed through different processes but may be provided in the same layer. Alternatively, the first bank BNK1 and the first and second bank patterns BNP1 and BNP2 may be formed through the same process to be provided in the same layer.

Light emitting elements LD may be supplied and aligned in the emission area EMA of the pixel PXL, in which the first insulating layer INS1 and the first bank BNK1 are formed. For example, the light emitting elements LD may be supplied (or input) to the emission area EMA through an inkjet printing process or the like, and be aligned between the alignment electrodes ALE by an electric field formed by a predetermined or selected signal (or alignment signal) applied to each of the alignment electrodes ALE. For example, the light emitting elements LD may be aligned on the first insulating layer INS1 between the first alignment electrode ALE1 and the second alignment electrode ALE2.

In an embodiment, each of the light emitting elements LD may include a light emitting stack pattern 10 and an insulating film 14 surrounding the light emitting stack structure 10.

The light emitting stack pattern 10 may include a first semiconductor layer 11, an active layer 12 (or light emitting layer), a second semiconductor layer 13, and an electrode layer 15, which are sequentially stacked in a direction toward a first end portion EP1 from a second end portion EP2 of the light emitting element LD. The first semiconductor layer 11 may include an n-type semiconductor layer, and the second semiconductor layer 13 may include a p-type semiconductor layer.

The insulating film 14 may include a first layer FRL surrounding an outer circumferential surface (or surface) of the light emitting stack pattern 10, a second layer SNL surrounding the first layer FRL, and a third layer TIL surrounding the second layer SNL. Each of the first, second, and third layers FRL, SNL, and TIL may expose each of a portion of the electrode layer 15 located at the first end portion EP1 of the light emitting element LD and a portion of the first semiconductor layer 11 located at the second end portion EP2 of the light emitting element LD, which have different polarities.

The first layer FRL and the third layer TIL may include the same material. The second layer SNL may include a material different from the material of the first and third layers FRL and TIL. In some embodiments, the first and third layers FRL and TIL may include at least one of zirconium oxide (ZrOₓ), hafnium oxide (HfOₓ), zirconium nitride (ZrN), hafnium nitride (HfN), zirconium oxynitride (ZrOₓN_{y}), and hafnium oxynitride (HfOₓN_{y}), and the second layer SNL may include aluminium oxide (Al₂O₃).

The third layer TIL may be configured to have a thickness relatively thicker than a thickness of each of the first and second layers FRL and SNL. In particular, the third layer TIL may be configured to have a thickness thicker than the thickness of the first layer FRL. For example, the first layer FRL may have a thickness of 5 nm or less, and the third layer TIL may have a thickness of 10 nm or less.

In the case that the multi-layer insulating film 14 including the first layer FRL, the second layer SNL, and the third layer TIL is disposed on the outer circumferential surface (or surface) of the light emitting stack structure 10, thereby surrounding the outer circumferential surface of the light emitting stack structure 10, thanks to interactions between the first, second, and third layers FRL, SNL, and TIL, the surface defect of the light emitting stack pattern 10 can be easily or effectively controlled, and the protective layer characteristic of the insulating film 14 is improved. Accordingly, the light emission efficiency of the light emitting element LD can be improved.

A second insulating layer INS2 (or insulating pattern) may be disposed on each of the light emitting elements LD. The second insulating layer INS2 may be located on each of the light emitting elements LD and partially cover an outer circumferential surface (or surface) of each of the light emitting elements LD, thereby exposing the first end portion EP1 and the second end portion EP2 of each of the light emitting elements LD to the outside.

The second insulating layer INS2 may include an inorganic insulating layer including an inorganic material or an organic insulating layer. For example, the second insulating layer INS2 may include an inorganic insulating layer suitable for protecting the active layer 12 of each of light emitting elements LD from external oxygen, moisture, and the like. The second insulating layer INS2 may be configured as a single layer or a multi-layer.

The second insulating layer INS2 is formed on light emitting elements LD which have been completely aligned in the emission area EMA of each pixel PXL, so that the light emitting elements LD can be prevented from being separated from positions at which the light emitting elements LD are aligned.

The electrodes PE may be formed on the first and second end portions EP1 and EP2 of the light emitting elements LD, which are not covered by the second insulating layer INS2. For example, the first electrode PE1 may be formed on the first end portions EP1 of the light emitting elements LD, and the second electrode PE2 may be formed on the second end portions EP2 of the light emitting elements LD.

The first electrode PE1 may be disposed on the top of the first alignment electrode ALE1 to overlap with the first alignment electrode ALE1, and the second electrode PE2 may be disposed on the top of the second alignment electrode ALE2 to overlap with the second alignment electrode ALE2.

The first electrode PE1 may be electrically connected to the first alignment electrode ALE1 through the first contact hole CH1 of the first insulating layer INS1, and the second electrode PE2 may be electrically connected to the second alignment electrode ALE2 through the second contact hole CH2 of the first insulating layer INS1.

Each of the first and second electrodes PE1 and PE2 may be configured with various transparent conductive materials. For example, each of the first and second electrodes PE1 and PE2 may include at least one of various transparent conductive materials including indium tin oxide, indium zinc oxide, indium tin zinc oxide, aluminium zinc oxide, gallium zinc oxide, zinc tin oxide, and gallium tin oxide, and be implemented substantially transparently or translucently to satisfy a predetermined transmittance. Accordingly, light emitted from the first and second end portions EP1 and EP2 of the light emitting elements LD can be emitted to the outside of the display device DD while passing through the first and second electrodes PE1 and PE2.

In an embodiment, the first electrode PE1 and the second electrode PE2 may be formed in different layers or the same layer. The mutual positions and/or a formation order of the first electrode PE1 and the second electrode PE2 may be variously changed in some embodiments.

In the embodiment shown in FIG. 13, the first electrode PE1 disposed adjacent to one side surface (e.g., a left side surface) of the second insulating layer INS2 may be first formed. After that, a third insulating layer INS3 may be formed to cover the first electrode PE1. The third insulating layer INS3 may be located over the first electrode PE1 and cover the first electrode PE1 (or allow the first electrode PE1 not to be exposed to the outside), thereby protecting the first electrode PE1. The third insulating layer INS3 may include an inorganic insulating layer made of an inorganic material or an organic insulating layer made of an organic material. Also, the third insulating layer INS3 may be formed as a single layer or a multi-layer. The second electrode PE2 may be formed on the third insulating layer INS3.

In the above-described embodiment, it has been described that the second electrode PE2 is formed after the first electrode PE1 and the third insulating layer INS3 are formed. However, the present disclosure is not limited thereto. In some embodiments, the second electrode PE2 disposed adjacent to the other side surface (e.g., a right side surface) of the second insulating layer INS2 may be first formed, the third insulating layer INS3 may be formed on the second electrode PE2, and the first electrode PE1 may be formed on the third insulating layer INS3.

In the case that electrodes disposed on a first end portion EP1 and a second end portion EP2 of each light emitting element LD are disposed in different layers, like the embodiment shown in FIG. 13, the electrodes can be stably separated from each other, and thus electrical stability between the first and second end portions EP1 and EP2 of the light emitting elements LD can be ensured.

In the embodiment shown in FIG. 14, the first electrode PE1 and the second electrode PE2 may be simultaneously formed with the second insulating layer INS2 interposed therebetween. For example, the first electrode PE1 may be located adjacent to one side surface (e.g., a left side surface) of the second insulating layer INS2, and the second electrode PE2 may be located adjacent to the other side surface (e.g., a right side surface) of the second insulating layer INS2. The first electrode PE1 may be in direct contact with the first end portion EP1 of the light emitting element LD, thereby being electrically connected to the light emitting element LD. The second electrode PE2 may be in direct contact with the second end portion EP2 of the light emitting element LD, thereby being electrically connected to the light emitting element LD. In the embodiment shown in FIG. 14, in the case that the first and second electrodes PE1 and PE2 disposed on the first end portion EP1 and the second end portion EP2 of the light emitting element LD are disposed in the same layer and are simultaneously formed, a manufacturing process of the pixel PXL can be simplified, and manufacturing efficiency can be improved.

In some embodiments, at least one overcoat layer (e.g., a layer for planarizing a top surface of the display element layer DPL) may be further disposed on the top of the first electrode PE1 and the second electrode PE2.

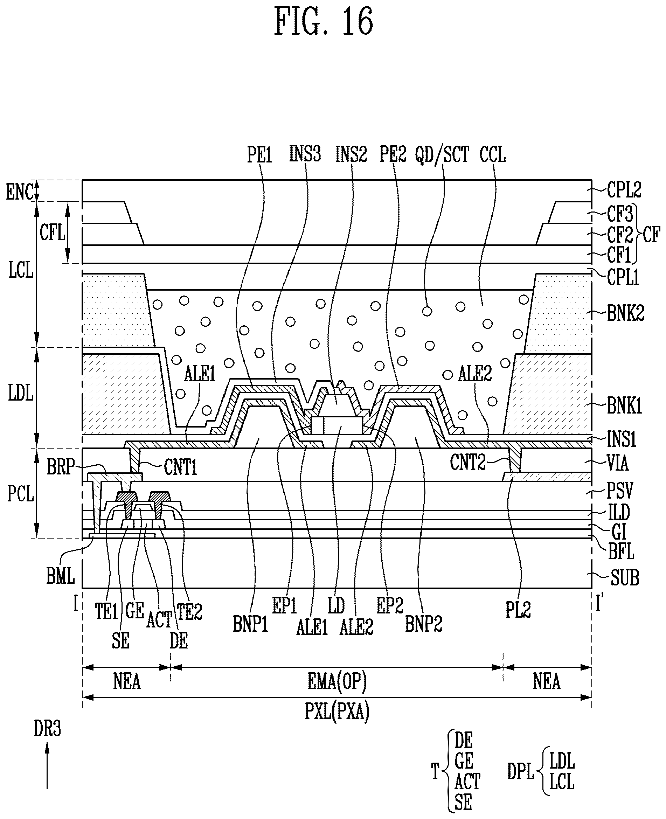

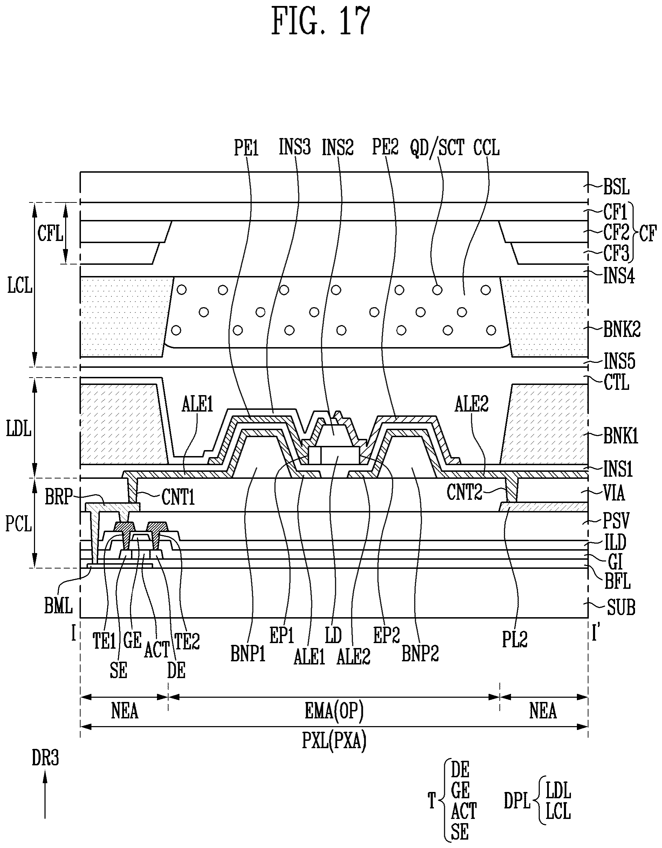

In other embodiments, an optical layer including a color conversion layer and a color filter layer, which convert light emitted from the light emitting elements LD into light having excellent color reproducibility and release the converted light, may be selectively provided on the top of the display element layer DPL. The optical layer will be described in detail later with reference to FIGS. 16 and 17.

FIGS. 16 and 17 are schematic cross-sectional views corresponding to the line I-I' shown in FIG. 12.

Embodiments shown in FIGS. 16 and 17 illustrate different modified examples in relation to a position of a color conversion layer CCL. For example, an embodiment in which an optical layer LCL including the color conversion layer CCL and a color filter layer CFL is located on the top of a light emitting element layer LDL through a continuous process is disclosed in FIG. 16, and an embodiment in which the optical layer LCL including the color conversion layer CCL and the color filter layer CFL is located on the light emitting element layer LDL through an adhesion process using and intermediate layer CTL is disclosed in FIG. 17.

In relation to embodiments shown in FIGS. 16 and 17, portions different from those of the above-described embodiment will be mainly described to avoid redundancy.

Referring to FIGS. 12 and 16, each pixel PXL may include a substrate SUB, a pixel circuit layer PCL, a display element layer DPL, and an encapsulation layer ENC. The display element layer DPL may include a light emitting element layer LDL and an optical layer LCL.

The light emitting element layer LDL may include first and second bank patterns BNP1 and BNP2, first and second alignment electrodes ALE1 and ALE2, a first bank BNK1, a light emitting element

LD, and first and second electrodes PE1 and PE2.

The optical layer LCL may include a color conversion layer CCL and a color filter layer CFL. Also, the optical layer LCL may include a second bank BNK2 and a first capping layer CPL1.

The second bank BNK2 may be disposed on the first bank BNK1 in a non-emission area NEA of the pixel PXL. The second bank BNK2 may be a dam structure which surrounds an emission area EMA of the pixel PXL and defines a position at which the color conversion layer CCL is to be supplied, thereby defining the emission area EMA.

The second bank BNK2 may include a light blocking material. For example, the second bank BNK2 may be a black matrix, but the present disclosure is not limited thereto. In some embodiments, the second bank BNK2 may include at least one light blocking material and/or at least one reflective material to allow light emitted from the color conversion layer CCL to further advance in the image display direction, thereby improving the light emission efficiency of the color conversion layer CCL.

The color conversion layer CCL may include color conversion particles QD corresponding to a specific color. For example, the color conversion layer CCL may include color conversion particles QD for converting light emitted from light emitting elements LD into light of a specific color (or light having excellent color reproducibility).

In the case that the pixel PXL is a red pixel, the color conversion layer CCL of the pixel PXL may include color conversion particles QD of a red quantum dot, which convert light emitted from the light emitting elements LD into light of red.

In the case that the pixel PXL is a green pixel, the color conversion layer CCL of the pixel PXL may include color conversion particles QD of a green quantum dot, which convert light emitted from the light emitting elements LD into light of green.

In the case that the pixel PXL is a blue pixel, the color conversion layer CCL of the pixel PXL may include color conversion particles QD of a blue quantum dot, which convert light emitted from the light emitting elements LD into light of blue. In some embodiments, in the case that the pixel is the blue pixel, the pixel PXL may include a light scattering layer including light scattering particles SCT, instead of the color conversion layer CCL including the color conversion particles QD. For example, in the case that the light emitting elements LD emits blue light, the pixel PXL may include the light scattering layer including the light scattering particles SCT. The above-described light scattering layer may be omitted in some embodiments. In other embodiments, in the case that the pixel PXL is the blue pixel, transparent polymer may be provided instead of the color conversion layer CCL.

The first capping layer CPL1 may be disposed over the color conversion layer CCL and the second bank BNK2.

The first capping layer CPL1 may be entirely provided in the display area (see "DA" shown in FIG. 10) in which the pixel is located to cover the second bank BNK2 and the color conversion layer CCL.

The first capping layer CPL1 may be an inorganic layer including an inorganic material. The first capping layer CPL1 may include at least one of silicon nitride (SiNₓ), silicon oxide (SiOₓ), silicon oxynitride (SiOₓN_{y}), and metal oxide such as aluminium oxide (AlOₓ). The first capping layer CPL1 entirely covers the second bank BNK2 and the color conversion layer CCL, thereby blocking external moisture, oxygen or the like from being introduced into the color conversion layer CCL.

In some embodiments, the first capping layer CPL1 may reduce a step difference occurring due to components disposed thereunder, and have a flat surface. For example, the first capping layer CPL1 may be an organic layer including an organic material, but the present disclosure is not limited thereto.

The color filter layer CFL may be disposed on the first capping layer CPL1.

The color filter layer CFL may include a color filter corresponding to an emission area EMA of each pixel PXL. For example, the color filter layer CFL may include a first color filter CF1 disposed on a color conversion layer CCL of one pixel PXL (hereinafter, referred to as a "first pixel"), a second color filter CF2 disposed on a color conversion layer of an adjacent pixel (hereinafter, referred to as a "second pixel") adjacent to the first pixel PXL, and a third color filter CF3 disposed on a color conversion layer of an adjacent pixel (hereinafter, referred to as a "third pixel") adjacent to the second pixel.

First, second, and third color filters CF1, CF2, and CF3 may be disposed while overlapping with each other in the non-emission area NEA, to be used as a light blocking member for blocking light interference between adjacent pixels PXL. Each of the first, second, and third color filters CF1, CF2, and CF3 may include a color filter material for allowing light converted in a corresponding color conversion layer CCL to be selectively transmitted therethrough. For example, the first color filter CF1 may be a red color filter, the second color filter CF2 may be a green color filter, and the third color filter CF3 may be a blue color filter. However, the present disclosure is not limited thereto.

The encapsulation layer ENC may be disposed on the color filter layer CFL.

The encapsulation layer ENC may include a second capping layer CPL2. The second capping layer CPL2 may be an inorganic including layer including an inorganic material or an organic insulating layer including an organic material. The second capping layer CPL2 may entirely cover components located thereunder, thereby blocking external moisture, humidity or the like from being introduced into the color filter layer CFL. In some embodiments, the encapsulation layer ENC may be used as a planarization layer for reducing a step difference generated by components of the color filter layer CFL located thereunder.

The second capping layer CPL2 may be formed as a multi-layer. For example, the second capping layer CPL2 may include at least two inorganic insulating layers and at least one organic insulating layer interposed between the at least two inorganic insulating layers. However, the material and/or structure of the second capping layer CPL2 may be variously changed. In some embodiments, at least one overcoat layer, at least one filler layer, and/or another substrate may be further disposed on the top of the second capping layer CPL2.

In the pixel PXL in accordance with the above-described embodiment, the color conversion layer CCL and the color filter layer CFL are disposed above the light emitting element LD through a continuous process, thereby releasing light having excellent color reproducibility through the color conversion layer CCL and the color filter layer CFL. Thus, the light emission efficiency of the pixel PXL can be improved.

In some embodiments, as shown in FIG. 17, the optical layer LCL may be formed on one surface of a base layer BSL through a continuous process, to constitute a separate substrate, e.g., an upper substrate, which is separate from the substrate SUB (e.g., a lower substrate) on which the light emitting element LDL is disposed. The upper substrate may be bonded to the display element layer LDL through an intermediate layer CTL. An insulating layer may be provided over the first and second electrodes PE1 and PE2 such that some components, e.g., the first and second electrodes PE1 and PE2 of the light emitting element layer LDL are not exposed to the outside in a process of bonding the light emitting element layer LDL and the upper substrate to each other.

The intermediate layer CTL may be a transparent adhesive layer (or cohesive layer), e.g., optically clear adhesive for reinforcing adhesion between the display element layer DPL and the upper substrate (or the optical layer LCL), but the present disclosure is not limited thereto. In some embodiments, the intermediate layer CTL may be a refractive index conversion layer for converting a refractive index of light which is emitted from light emitting elements LD and then advances toward the upper substrate, thereby improving the light emitting luminance of the pixel PXL. In some embodiments, the intermediate layer CTL may include a filler configured with an insulating material having insulating and adhesive properties.

The upper substrate may include the base layer BSL and the optical layer LCL. The optical layer LCL may include the color filter layer CFL, the second bank BNK2, the color conversion layer CCL, and a fifth insulating layer INS5.

The base layer BSL may be a rigid substrate or a flexible substrate, and the material and property of the base layer BSL are not particularly limited. The base layer BSL may be configured with the same material as the substrate SUB, or be configured with a material different from the material of the substrate SUB.

The color filter layer CFL may be disposed on one surface of the base layer BSL to face the display element layer LDL. A first color filter CF1 of the color filter layer CFL may be provided on the one surface of the base layer BSL to correspond to the color conversion layer CCL in the emission area EMA. First, second, and third color filters CF1, CF2, and CF3 of the color filter layer CFL may be disposed in the non-emission area NEA to overlap with each other. Therefore, the first, second, and third color filters CF1, CF2, and CF3 of the color filter layer CFL may be used as a light blocking member.

A fourth insulating layer INS4 may be disposed between the color filter layer CFL and the color conversion layer CCL.

The fourth insulating layer INS4 may be located over the color filter layer CFL, thereby covering the color filter layer CFL. Thus, the fourth insulating layer INS4 can protect the color filter layer CFL. The fourth insulating layer INS4 may be an inorganic insulating layer including an inorganic material or an organic insulating layer including an organic material.

The second bank BNK2 and the color conversion layer CCL may be located on one surface of the fourth insulating layer INS4.

The fifth insulating layer INS5 may be entirely disposed over the second bank BNK2 and the color conversion layer CCL.

The fifth insulating layer INS5 may include at least one of silicon nitride (SiNₓ), silicon oxide (SiOₓ), and silicon oxynitride (SiOₓN_{y}), or include at least one of metal oxides such as aluminium oxide (AlOₓ). However, the present disclosure is not limited thereto. In some embodiments, the fifth insulating layer INS5 may be configured as an organic layer including an organic material. The fifth insulating layer INS5 may be located over the color conversion layer CCL, thereby protecting the color conversion layer CCL from external moisture, humidity, and the like. Thus, the reliability of the color conversion layer CCL can be further improved.

While the present invention has been described above with reference to preferred embodiments, those skilled in the art or those having ordinary knowledge in the relevant technical field will understand that various modifications and changes can be made to the present invention without departing from the technical scope defined in the claims described below.

Therefore, the technical scope of the present invention should not be limited to the detailed description in the specification, but should be defined by the claims.

## Claims

1. A light emitting element comprising:
a light emitting stack pattern including a first semiconductor layer, an active layer, and a second semiconductor layer; and
an insulating film surrounding an outer circumferential surface of the light emitting stack pattern,
wherein the insulating film includes:
a first layer;
a second layer surrounding the first layer; and
a third layer surrounding the second layer, and
wherein the first layer and the third layer include the same material.

2. The light emitting element of claim 1, wherein the first layer and the third layer include at least one of ZrOₓ, SiOₓ, HFOₓ, BeO, TaₓO_{y}, AlₓO_{y}, LaₓO_{y}, NbₓO_{y}, TiOₓ, CeOₓ, MgO, YₓO_{y}, and SrₓO_{y}.

3. The light emitting element of claim 1, wherein the first layer and the third layer include at least one of AIN, AlGaN, InGaN, SiNₓ, AlOₓN_{y}, HfN, ZrN, HfOₓN_{y}, and ZrOₓN_{y}.

4. The light emitting element of claim 3, wherein the first layer has a thickness of 5 nm or less, and the third layer has a thickness of 10 nm or less.

5. The light emitting element of claim 1, wherein the second layer includes a material different from the material of the first and third layers.

6. The light emitting element of claim 1, wherein the first layer is disposed directly on an outer circumferential surface of each of the first semiconductor layer, the active layer, and the second semiconductor layer.

7. The light emitting element of claim 1, wherein the first semiconductor layer includes an n-type semiconductor layer doped with an n-type dopant, and the second semiconductor layer includes a p-type semiconductor layer doped with a p-type dopant.

8. The light emitting element of claim 7, wherein the light emitting stack pattern further includes an electrode layer disposed on the second semiconductor layer, and
wherein the insulating film is disposed directly on an outer circumferential surface of each of the first semiconductor layer, the active layer, the second semiconductor layer, and the electrode layer.

9. The light emitting element of claim 1, wherein the insulating film further includes a fourth layer surrounding the third layer, and
wherein the fourth layer includes an inorganic insulating material, and has a thickness thicker than a thickness of each of the first to third layers.

10. The light emitting element of claim 9, wherein the insulating film further includes a fifth layer surrounding the fourth layer, and
wherein the fifth layer includes an inorganic insulating material, and has a thickness thicker than a thickness of each of the first to fourth layers.

11. A light emitting element comprising:
a light emitting stack pattern including a first semiconductor layer, an active layer, a second semiconductor layer, and an electrode layer, which are sequentially stacked along one direction; and
an insulating film surrounding an outer circumferential surface of the light emitting stack pattern,
wherein the insulating film includes:
a first layer disposed directly on the outer circumferential surface of the light emitting stack pattern to surround the light emitting stack pattern;
a second layer surrounding the first layer;
a third layer surrounding the second layer;
a fourth layer surrounding the third layer; and
a fifth layer surrounding the fourth layer, and
wherein the first layer and the third layer include the same material, and the second layer includes a material different from a material of the first and third layers.

12. The light emitting element of claim 11, wherein the first layer and the third layer include at least one of ZrOₓ, SiOₓ, HFOₓ, BeO, TaₓO_{y}, AlₓO_{y}, LaₓO_{y}, NbₓO_{y}, TiOₓ, CeOₓ, MgO, YₓO_{y}, and SrₓO_{y}.

13. The light emitting element of claim 11, wherein the first layer and the third layer include at least one of AIN, AlGaN, InGaN, SiNₓ, AlOₓN_{y}, HfN, ZrN, HfOₓN_{y}, and ZrOₓN_{y}.

14. The light emitting element of claim 11, wherein the first layer has a thickness of 5 nm or less, and the third layer has a thickness of 10 nm or less.

15. The light emitting element of claim 11, wherein the fourth layer and the fifth layer include an inorganic insulating material.

16. A display device comprising:
a substrate;
a first electrode and a second electrode disposed on the substrate to be spaced apart from each other; and
a light emitting element located on the substrate, the light emitting element including a first end portion electrically connected to the first electrode and a second end portion electrically connected to the second electrode,
wherein the light emitting element includes:
a light emitting stack pattern including a first semiconductor layer located at the second end portion, an active layer disposed on the first semiconductor layer, a second semiconductor layer disposed on the active layer, and an electrode layer which is disposed on the second semiconductor layer and is located at the first end portion; and
an insulating film surrounding an outer circumferential surface of the light emitting stack pattern,
wherein the insulating film includes:
a first layer disposed directly on the outer circumferential surface of the light emitting stack pattern;
a second layer surrounding the first layer; and
a third layer surrounding the second layer, and
wherein the first layer and the third layer include the same material, and the second layer includes a material different from the material of the first and third layers.

17. The display device of claim 16, wherein the first layer and the third layer include at least one of ZrOₓ, SiOₓ, HFOₓ, BeO, TaₓO_{y}, AlₓO_{y}, LaₓO_{y}, NbₓO_{y}, TiOₓ, CeOₓ, MgO, YₓO_{y}, and SrₓO_{y}.

18. The display device of claim 16, wherein the first layer and the third layer include at least one of AIN, AlGaN, InGaN, SiNₓ, AlOₓN_{y}, HfN, ZrN, HfOₓN_{y}, and ZrOₓN_{y}.

19. The display device of claim 16, wherein the first layer has a thickness of 5 nm or less, and the third layer has a thickness of 10 nm or less.

20. The display device of claim 16, further comprising:
an emission area in which light is emitted from the light emitting element and a non-emission area surrounding the emission area;
a first alignment electrode disposed between the substrate and the first electrode, the first alignment electrode being electrically connected to the first electrode;
a second alignment electrode disposed between the substrate and the second electrode, the second alignment electrode being electrically connected to the second electrode;
a first bank located in the non-emission area, the first bank including an opening corresponding to the emission area;
a second bank located on the first bank;
a color conversion layer surrounded by the second bank, the color conversion layer being located above the light emitting element; and
a color filter disposed on the color conversion layer.
